# EUROPÄISCHE PATENTSCHRIFT

(11) **EP 3 341 441 B1**
(45) Veröffentlichungstag und Bekanntmachung des Hinweises auf die Patenterteilung: **06.02.2019**
(21) Anmeldenummer: 16806162.0
(22) Anmeldetag: 07.12.2016
(51) Int. Cl.: C08L 83/04

(54) **SILOXANHARZZUSAMMENSETZUNGEN**
SILOXANE RESIN COMPOSITIONS
COMPOSITIONS DE RÉSINE DE SILOXANE

(30) Priorität: 18.12.2015 DE 102015225921
(43) Veröffentlichungstag der Anmeldung: 04.07.2018
(73) Patentinhaber: Wacker Chemie AG, 81737 München (DE)
(72) Erfinder: KUHN, Arvid, 84489 Burghausen (DE); JOO, Young-Hyuk, Suwon-si, Gyeonggi-do 16674 (KR); SANDMEYER, Frank, 84508 Burgkirchen (DE); YANG, Hyun-Kwan, Yongin-si, Gyeonggi-do 16854 (KR)
(74) Vertreter: Budczinski, Angelika
(86) Internationale Anmeldenummer: PCT/EP2016/080087
(87) Internationale Veröffentlichungsnummer: WO 2017/102502

(56) Entgegenhaltungen:
- EP-A1- 2 730 620

## Beschreibung

Die Erfindung betrifft Siloxanharzzusammensetzungen, Verfahren zu deren Herstellung sowie deren Verwendung zur Herstellung von elektrisch isolierenden Formkörpern und optischen Halbleiterelementen.

Die Anforderungen an Bindemittel und Zubereitungen zur Herstellung elektrisch isolierender Bauteile sind umfangreich und anspruchsvoll und umfassen beispielsweise:
- gute Oberflächenhärte,
- bei gleichzeitiger Flexibilität,
- gute Lichtstabilität,
- gute Wetterbeständigkeit,
- gute Temperaturbeständigkeit,
- geringe Gasdurchlässigkeit und somit Vermeidung von Korrosion,
- hohe Transparenz;
- hoher Brechungsindex;
- keine Vergilbung (Verfärbung durch Wärme);
- gute verfahrenstechnische Eigenschaften bei der Verarbeitung, wie beispielsweise gute Formgebungseigenschaften, rasche und steuerbare Aushärtung zum Formkörper, robuste, fehlertolerante Verarbeitungseigenschaften, prozessangepasste Viskosität,
- Kosteneffizienz,
wobei nicht alle diese Eigenschaften in jeder Anwendung in gleich hoher Ausprägung vorhanden sein müssen.

Im bisherigen Stand der Technik sind bereits viele Lösungsvorschläge offenbart worden. Hierzu sei beispielsweise auf WO-A 15014890 sowie US-A 7,527,871 und EP 2 730 620 verwiesen.

Die Verwendung von additionsvernetzenden Siliconzusammensetzungen für die Herstellung von LEDs ist bereits bekannt. Häufig handelt es sich dabei um mehrkomponentige Systeme, die aus mindestens einem Organopolysiloxan mit mindestens zwei aliphatisch ungesättigten Gruppen im Molekül und mindestens einem Organohydrogenpolysiloxan mit zwei oder mehr Si-H-Gruppen im Molekül sowie mindestens einem Hydrosilylierungskatalysator und meist weiteren Formulierungskomponenten bestehen. In der Mehrzahl der Zubereitungen sind die beiden zur Hydrosilylierung erforderlichen komplementären Funktionen Si-H und Si-Vinyl auf verschiedene Polyorganosiloxane der Zubereitung verteilt.

Gegenstand der Erfindung sind Zusammensetzungen enthaltend
(A) Organopolysiloxane aus mindestens 3 Einheiten der Formel

   R¹ₐR²_{b}R³_{c}H_{d}(RO)ₑSiO_{(4-a-b-c-d-e)/2} (I),

   wobei
   - R¹: gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
   - R²: gleich oder verschieden sein kann und einwertige, SiC-gebundene, gegebenenfalls halogen- oder cyanosubstituierte, gesättigte Kohlenwasserstoffreste darstellen,
   - R³: gleiche oder verschiedene einwertige SiC-gebundene aromatische Reste darstellen,
   - R: gleich oder verschieden sein kann und Wasserstoffatom oder einwertige, gegebenenfalls substituierte Kohlenwasserstoffreste darstellen, die mit Heteroatomen unterbrochen sein können,
   - a: 0, 1, 2 oder 3, bevorzugt 0 oder 1, ist,
   - b: 0, 1, 2 oder 3, bevorzugt 0 oder 2, ist,
   - c: 0, 1, 2 oder 3, bevorzugt 0 oder 1, ist,
   - d: 0, 1 oder 2, bevorzugt 0 oder 1, ist und
   - e: 0, 1 oder 2, bevorzugt 0 oder 1, insbesondere 0, ist,
   mit der Maßgabe, dass die Summe a+b+c+d+e kleiner oder gleich 3 ist, die Summe aus Si-gebundenen Wasserstoffatomen und Resten R¹ pro Molekül mindestens 3 beträgt, in mindestens 10 mol-% der Einheiten der Formel (I) die Summe a+b+c+d gleich 0 oder 1 ist und in mindestens einer Einheit c verschieden 0 ist sowie im Siloxan (A) das Verhältnis von Si-gebundenen Wasserstoffatomen zu Si-gebundenen Resten R¹ bei 0,1 bis 0,9 liegt, gegebenenfalls (B) Organopolysiloxane aus Einheiten der Formel

   R⁴_{f}R⁵_{g}R⁶ₕ(R⁷O)ᵢSiO_{(4-f-g-h-i)/2} (VI),

   wobei
   - R⁴: gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
   - R⁵: gleich oder verschieden sein kann und einwertige, SiC-gebundene, gegebenenfalls halogen- oder cyanosubstituierte, gesättigte Kohlenwasserstoffreste darstellen,
   - R⁶: gleiche oder verschiedene einwertige SiC-gebundene aromatische Reste darstellen,
   - R⁷: gleich oder verschieden sein kann und Wasserstoffatom oder einwertige, gegebenenfalls substituierte Kohlenwasserstoffreste darstellen, die mit Heteroatomen unterbrochen sein können,
   - f: 0, 1, 2 oder 3, bevorzugt 0 oder 1, ist,
   - g: 0, 1, 2 oder 3, bevorzugt 1 oder 2, ist,
   - h: 0, 1 oder 2, bevorzugt 0 oder 1, ist und
   - i: 0 oder 1, bevorzugt 0, ist,
   mit der Maßgabe, dass die Summe f+g+h+i kleiner oder gleich 3 ist, Siloxane (B) mindestens zwei Reste R⁴ pro Molekül aufweisen, in maximal 20 mol-% der Einheiten der Formel (VI) die Summe f+g+h+i gleich 0 oder 1 ist und in mindestens einer Einheit der Formel (VI) h verschieden 0 ist,
(C) Organopolysiloxane aus Einheiten der Formel

   R⁸ₖR⁹ₗR¹⁰ₘ(R¹¹O)ₙSiO_{(4-k-l-m-n)/2} (X),

   wobei
   - R⁸: gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
   - R⁹: gleich oder verschieden sein kann und einwertige, SiC-gebundene, gegebenenfalls halogen- oder cyanosubstituierte, gesättigte Kohlenwasserstoffreste darstellen,
   - R¹⁰: gleiche oder verschiedene einwertige SiC-gebundene aromatische Reste darstellen,
   - R¹¹: gleich oder verschieden sein kann und Wasserstoffatom oder einwertige, gegebenenfalls substituierte Kohlenwasserstoffreste darstellen, die mit Heteroatomen unterbrochen sein können,
   - k: 0, 1, 2 oder 3, bevorzugt 0 oder 1, ist,
   - l: 0, 1, 2 oder 3, bevorzugt 0, 1 oder 2, ist,
   - m: 0, 1 oder 2, bevorzugt 0 oder 1, ist und
   - n: 0 oder 1, bevorzugt 0, ist,
   mit der Maßgabe, dass die Summe k+l+m+n kleiner oder gleich 3 ist, Siloxane (C) mindestens zwei Reste R⁸ pro Molekül aufweisen, in mindestens 10 mol-% der Einheiten der Formel (X) die Summe k+l+m+n gleich 0 oder 1 ist und in mindestens einer Einheit der Formel (X) m verschieden 0 ist,
   sowie
   gegebenenfalls (D) die Anlagerung von Si-gebundenem Wasserstoff an aliphatische Kohlenstoff-Kohlenstoff-Mehrfachbindungen fördernden Katalysator.

Bevorzugt sind in den Siloxanen (A) sowohl Si-gebundene Wasserstoffatome als auch Reste R¹ überwiegend, bevorzugt ausschließlich, an Siliziumatome von Einheiten der Formel (I) gebunden, bei denen die Summe a+b+c+d+e gleich 3 ist. Besonders bevorzugt sind in den Siloxanen (A) sowohl Si-gebundene Wasserstoffatome als auch Reste R¹ überwiegend, bevorzugt ausschließlich, an Siliziumatome von Einheiten der Formel (I) gebunden, bei denen die Summe a+b+c+d gleich 3 ist, d.h. an sogenannte M-Einheiten, die keine Gruppen (OR) tragen. Mit diesen terminalen Funktionalitäten im Siloxan (A) wird sichergestellt, dass sie für chemische Reaktionen mit einem komplementär funktionalisierten Reaktionspartner leicht zugänglich und verfügbar sind. Dadurch ergibt sich der überraschende Vorteil, dass lediglich ein Minimum an funktionellen Gruppen benötigt wird, um zu einem gehärteten Festkörper zu gelangen.

Die erfindungsgemäß eingesetzten Siloxane (A) enthalten Einheiten der Formel (I) mit a+b+c+d gleich 0 oder 1 in Mengen von vorzugsweise mindestens 20 mol-%, bevorzugt mindestens 25 mol-%, besonders bevorzugt mindestens 30 mol-%, insbesondere 35 bis 70 mol-%. Da Einheiten der Formel (I) mit a+b+c+d gleich 0 je nach Anforderungsprofil leicht zu einer meist unerwünschten Versprödung führen können, sind Einheiten der Formel (I) mit a+b+c+d gleich 1 als Verzweigungseinheiten bevorzugt.

Bevorzugt enthalten die erfindungsgemäß eingesetzten Siloxane (A) keine Einheiten der Formel (I) mit a+b+c+d=0.

Einheiten der Formel (I) mit a+b+c+d gleich 2 können u.a. zur Einstellung der Mechanik dienen, da sie weich machen und Flexibilität verleihen. Die erfindungsgemäß eingesetzten Siloxane (A) enthalten vorzugsweise maximal 25 mol-% Einheiten der Formel (I) mit a+b+c+d=2, bevorzugt maximal 5 mol-%, besonders bevorzugt maximal 2 mol-%, insbesondere keine.

Vorzugsweise handelt es sich bei Rest R¹, R⁴ und R⁸ jeweils unabhängig voneinander um aliphatische Mehrfachbindung aufweisende Kohlenwasserstoffreste mit 2 bis 8 Kohlenstoffatomen, wie Vinyl-, Allyl-, Methallyl-, 2-Propenyl-, 3-Butenyl-, 4-Pentenylrest, 5-Hexenyl-, 1,3-Butadienyl-, Hexadienyl-, Cyclopentenyl-, Cyclopentadienyl-, Cyclohexenyl-, Ethinyl-, Propargyl-, 2-Propinyl- und Isoprenylrest, wobei der Vinyl- oder Allylrest besonders bevorzugt sind, insbesondere der Vinylrest.

Beispiele für Reste R², R⁵ und R⁹ sind unabhängig voneinander Alkylreste, wie der Methyl-, Ethyl-, n-Propyl-, iso-Propyl-, n-Butyl-, iso-Butyl-, tert.-Butyl-, n-Pentyl-, iso-Pentyl-, neoPentyl-, tert.-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, und Cycloalkylreste, wie Cyclopentyl-, Cyclohexyl-, Cycloheptyl- und Methylcyclohexylreste.

Vorzugsweise handelt es sich bei Rest R², R⁵ und R⁹ unabhängig voneinander um gesättigte Kohlenwasserstoffreste mit 1 bis 12 Kohlenstoffatomen, besonders bevorzugt um gesättigte Kohlenwasserstoffreste mit 1 bis 4 Kohlenstoffatomen, insbesondere um den Methylrest.

Beispiele für Reste R³, R⁶ und R¹⁰ sind unabhängig voneinander Arylreste, wie der Phenyl-, der Naphthyl-, Anthryl- und Phenanthrylrest, der Indenyl-, Benzophenyl-, Fluorenyl-, Xanthenyl- und Anthronylrest; Aryloxy-arylreste, wie o- und p-Phenoxyphenylreste; Alkarylreste, wie o-, m-, p-Tolylreste, Xylylreste und Ethylphenylreste; Aralkylreste, wie der Benzylrest, der α- und der β-Phenylethylrest.

Vorzugsweise handelt es sich bei Rest R³, R⁶ und R¹⁰ unabhängig voneinander um Arylreste wie den Phenyl- oder Naphthylrest, besonders bevorzugt um den Phenylrest.

Beispiele für Reste R, R⁷ und R¹¹ sind die für Rest R² und R³ angegebenen Reste.

Bevorzugt handelt es sich bei den Resten R, R⁷ und R¹¹ um Wasserstoffatom, den Methyl- oder den Ethylrest, besonders bevorzugt um Wasserstoffatom.

Bevorzugt handelt es sich bei Komponente (A) um Siloxane mit mindestens 3 Einheiten ausgewählt aus solchen der Formeln

R¹ₐR²_{b}R³_{c}H_{d}(RO)ₑSiO_{1/2} mit (a+b+c+d+e) = 3 (II),

R²_{b}R³_{c}(RO)SiO_{2/2} mit (b+c) = 1 (IIIa),

R²_{b}R³_{c}SiO_{2/2} mit (b+c) = 2 (IIIb),

R²_{b}R³_{c}(RO)ₑSiO_{3/2} mit (b+c+e) = 1 (IV)

und

SiO_{4/2} (V),

wobei R, R¹, R², R³, a, b, c, d und e eine der oben angegebenen Bedeutungen haben,
mit der Maßgabe, dass in den Siloxanen (A) vorzugsweise maximal 25 mol-%, bevorzugt maximal 5 mol-%, der Einheiten der Formel (IIIb) entsprechen, die Summe aus Si-gebundenen Wasserstoffatomen und Resten R¹ pro Molekül mindestens 3 ist, pro Molekül mindestens ein Rest R³ anwesend ist und mindestens eine Einheit der Formel (IV) und/oder (V) anwesend ist.

Bevorzugt bestehen die erfindungsgemäß eingesetzten Siloxane (A) aus 3 bis 1000, besonders bevorzugt 3 bis 150, insbesondere 3 bis 50, Einheiten der Formel (I).

Die erfindungsgemäß eingesetzten Siloxane (A) enthalten bevorzugt mindestens 5 mol-% Einheiten der Formel (II), mindestens 30 mol-% Einheiten der Formel (IV), höchstens 25 mol-% Einheiten der Formel (IIIb) und höchstens 20 mol-% Einheiten der Formel (V).

Besonders bevorzugt handelt es sich bei Komponente (A) um Siloxane bestehend aus mindestens einer Einheit ausgewählt aus R²₃SiO_{1/2}-, R¹R²₂SiO_{1/2}-, R²₂HSiO_{1/2}-, R²₂R³SiO_{1/2}-, R²R³₂SiO_{1/2}-, R¹R²R³SiO_{1/2}- und R²R³HSiO_{1/2}-Einheiten sowie mindestens einer Einheit ausgewählt aus R³SiO_{3/2}-, ROSiO_{3/2}- und R²SiO_{3/2}-Einheiten sowie gegebenenfalls Einheiten (IIIb) ausgewählt aus R²₂SiO_{2/2}-, R²R³SiO_{2/2}- und R³₂SiO_{2/2}-Einheiten sowie gegebenenfalls R² (RO) SiO_{2/2}- und R³ (RO) SiO_{2/2}-Einheiten, wobei R, R¹, R² und R³ eine der oben angegebenen Bedeutungen haben,
mit der Maßgabe, dass die Siloxane (A) mindestens 3 Siloxyeinheiten aufweisen, die Summe aus Si-gebundenen Wasserstoffatomen und Resten R¹ pro Molekül mindestens 3 ist und pro Molekül mindestens ein Rest R³ anwesend ist und höchstens 25 mol-% Einheiten der Formel (IIIb) enthalten sind.

Bevorzugte Beispiele für Komponente (A) sind Siloxane bestehend aus mindestens einer Einheit ausgewählt aus Me₃SiO_{1/2}-, ViMe₂SiO_{1/2}-, Me₂HSiO_{1/2}-, Me₂PhSiO_{1/2}-, MePh₂SiO_{1/2}-, ViMePhSiO_{1/2}- und MePhHSiO_{1/2}-Einheiten sowie mindestens einer Einheit ausgewählt aus PhSiO_{3/2}-, HOSiO_{3/2}-, Ph(HO)SiO_{2/2}, und MeSiO_{3/2}-Einheiten mit Me gleich Methylrest, Vi gleich Vinylrest und Ph gleich Phenylrest,
mit der Maßgabe, dass die Siloxane (A) aus 3 bis 50 Siloxyeinheiten bestehen, die Summe aus Si-gebundenen Wasserstoffatomen und Vinylresten pro Molekül mindestens 3 ist und pro Molekül mindestens ein Phenylrest anwesend ist.

Die erfindungsgemäß eingesetzten Siloxane (A) weisen bevorzugt keine Reste (OR) auf. Falls sie jedoch, z.B. herstellungsbedingt, Reste (OR) aufweisen, handelt es sich um Mengen von bevorzugt ≤ 5 Gew.-%, besonders bevorzugt ≤ 5000 Gew.-ppm, insbesondere ≤ 1000 Gew.-ppm.

Der molare Anteil an Si-gebundenen Wasserstoffatomen an der Gesamtzahl der Si-gebundenen Reste beträgt im Siloxan (A) bevorzugt 0,1 bis 50 %, besonders bevorzugt 2 bis 40 %, insbesondere 5 bis 30 %. Die Bestimmung erfolgt dabei bevorzugt mittels ²⁹Si-NMR-Spektroskopie.

Der molare Anteil an Resten R¹ an der Gesamtzahl der Si-gebundenen Reste beträgt im Siloxan (A) bevorzugt 1 bis 50 %, besonders bevorzugt 1 bis 40 %, insbesondere 5 bis 30 %. Die Bestimmung erfolgt dabei bevorzugt mittels ²⁹Si-NMR-Spektroskopie.

Im erfindungsgemäß eingesetzten Siloxan (A) liegt das Verhältnis von Si-gebundenen Wasserstoffatomen zu Si-gebundenen Resten R¹ bei 0,1 bis 9, bevorzugt bei 0,8 bis 7, besonders bevorzugt bei 0,9 bis 5, insbesondere bei 1,0 bis 2,5.

Der molare Anteil der mindestens einen aromatischen Rest R³ tragenden Siliziumatome zur Gesamtanzahl der Siliziumatome im Siloxan (A) beträgt vorzugsweise mindestens 30 %, bevorzugt 40 % bis 75 %, insbesondere 45 % bis 60 %.

Siloxane (A) haben ein mittleres Molekulargewicht Mw von vorzugsweise mindestens 600 g/mol, bevorzugt mindestens 700 g/mol, besonders bevorzugt mindestens 800 g/mol, insbesondere zwischen 900 und 5000 g/mol, wobei die Polydispersität vorzugsweise höchstens 20, bevorzugt höchstens 15, besonders bevorzugt höchstens 10, insbesondere höchstens 6 ist, gemessen mittels SEC, THF als Eluent, Konzentration 5 mg /ml, RI Detektor, gegen Polystyrol als Standard.

Die erfindungsgemäß eingesetzten Siloxanharze (A) können bei 23°C und 1000 hPa sowohl fest als auch flüssig sein, wobei Siloxane (A) bevorzugt flüssig sind.

Die Viskosität der erfindungsgemäß eingesetzten Siloxane (A) beträgt bevorzugt zwischen 10 und 20 000 mPas, besonders bevorzugt zwischen 20 und 15 000 mPas, insbesondere zwischen 30 und 10 000 mPas, ganz besonders bevorzugt zwischen 40 und 8 000 mPas .

In einer weiteren Ausführungsform handelt es sich bei Siloxanen (A) um bei 23°C und einem Druck von 1013 hPa nicht mehr fließfähige standfeste Massen mit noch klebriger Oberfläche oder um klebfreie Festkörper mit einer Glasübergangstemperatur von mehr als 25°C.

Die erfindungsgemäß eingesetzten Siloxanharze (A) sind bereits bekannt und können nach unterschiedlichen, dem Fachmann bekannten Verfahren hergestellt werden, wie beispielsweise durch Umsetzung von Chlorsilanen mit Wasser. Hierzu sei beispielsweise auf US-A 7,666,969 verwiesen.

Die Siloxane (A) können sowohl in reiner Form als auch in Form einer Mischung mit einem geeigneten Lösungsmittel eingesetzt werden, wobei ein Einsatz in reiner Form jedoch bevorzugt wird.

Falls Lösungsmittel eingesetzt wird, hängt die Auswahl von der jeweiligen organischen funktionellen Gruppe in Komponente (A) ab. Zweckmäßigerweise werden Lösungsmittel gewählt, die gegenüber Komponente (A) nicht reaktiv sind. Beispiele für geeignete Lösungsmittel sind aromatische Lösemittel, wie Toluol, Xylol, Ethylbenzol oder Mischungen derselben sowie Kohlenwasserstoffe bzw. deren Gemische wie beispielsweise handelsübliche Isoparaffinmischungen und andere.

Bevorzugt sind in den gegebenenfalls eingesetzten Siloxanen (B) Reste R⁴ überwiegend, bevorzugt ausschließlich, an Siliziumatome von Einheiten der Formel (VI) gebunden, bei denen die Summe f+g+h gleich 3 ist.

Bevorzugt handelt es sich bei Komponente (B) um Siloxane bestehend aus Einheiten, ausgewählt aus solchen der Formeln

R⁴_{f}R⁵_{g}R⁶ₕ(R⁷O)ᵢSiO_{1/2} mit (f+g+h+i) = 3 (VII),

R⁵_{g}R⁶ₕ(R⁷O)SiO_{2/2} mit (g+h) = 1 (VIIIa),

R⁵_{g}R⁶ₕSiO_{2/2} mit (g+h) = 2 (VIIIb),

R⁵_{g}R⁶ₕ(R⁷O)ᵢSiO_{3/2} mit(g+h+i) = 1 (IX)

und

SiO_{4/2} (V),

wobei R⁴, R⁵, R⁶, R⁷, f, g, h und i eine der oben angegebenen Bedeutungen haben,
mit der Maßgabe, dass Siloxane (B) mindestens zwei Reste R⁴ pro Molekül aufweisen, maximal 20 mol-% der Einheiten den Formeln (IX) oder (V) entsprechen und pro Molekül mindestens ein Rest R⁶ anwesend ist.

Die erfindungsgemäß gegebenenfalls eingesetzten Siloxane (B) enthalten bevorzugt mindestens 30 mol-% Einheiten der Formel (VIIIb).

Besonders bevorzugt handelt es sich bei Komponente (B) um Siloxane bestehend aus mindestens zwei Einheiten ausgewählt aus R⁴R⁵₂SiO_{1/2}, R⁴R⁵R⁶SiO_{1/2} und R⁴R⁶₂SiO_{1/2}-Einheiten sowie mindestens einer Einheit ausgewählt aus R⁵₂SiO_{2/2}, R⁵R⁶SiO_{2/2} und R⁶₂SiO_{2/2}-Einheiten, wobei R⁴, R⁵ und R⁶ eine der oben angegebenen Bedeutungen haben.

Bevorzugt bestehen die erfindungsgemäß gegebenenfalls eingesetzten Siloxane (B) aus 3 bis 1000 Siloxyeinheiten, besonders bevorzugt aus 4 bis 500 Einheiten, insbesondere aus 8 bis 100 Einheiten.

Insbesondere handelt es sich bei den erfindungsgemäß gegebenenfalls eingesetzten Siloxanen (B) um lineare Organopolysiloxane der Struktur

(R⁴R⁵₂SiO_{1/2})(R⁶R⁵SiO)₁₋₁₀₀(R⁵₂SiO)₀₋₇₀(R⁴R⁵₂SiO_{1/2}),

wobei R⁴, R⁵ und R⁶ eine der oben angegebenen Bedeutungen hat und die (R⁶R⁵SiO)-Einheiten und (R⁵₂SiO)-Einheiten statistisch im Molekül verteilt sein können.

Beispiele für erfindungsgemäß gegebenenfalls eingesetzte Siloxane (B) sind (Me₂ViSiO_{1/2})₂(MePhSiO_{2/2})₆₀(Me₂SiO_{2/2})₁₂, (Me₂ViSiO_{1/2})₂(MePhSiO_{2/2})₁₀(Me₂SiO_{2/2})₂, (Me₂ViSiO_{1/2})₂(MePhSiO_{2/2}) und (Me₂ViSiO_{1/2})₂(Ph₂SiO_{2/2}) mit Me gleich Methylrest, Vi gleich Vinylrest und Ph gleich Phenylrest.

Die erfindungsgemäß gegebenenfalls eingesetzten Siloxane (B) haben bei 25°C Viskositäten von bevorzugt 10 bis 100 000 mPas, besonders bevorzugt 100 bis 20 000 mPas.

Falls die erfindungsgemäßen Zusammensetzungen Komponente (B) enthalten, handelt es sich um Mengen von vorzugsweise 1 bis 200 Gewichtsteilen, besonders bevorzugt 10 bis 150 Gewichtsteilen, insbesondere 20 bis 120 Gewichtsteilen, jeweils bezogen auf 100 Gewichtsteile Komponente (A). In einer bevorzugten Ausführungsform enthalten die erfindungsgemäßen Zusammensetzungen keine Komponente (B).

Die erfindungsgemäß gegebenenfalls eingesetzten Siloxane (B) sind handelsübliche Produkte bzw. nach in der Chemie gängigen Verfahren herstellbar.

Bevorzugt sind in den erfindungsgemäß eingesetzten Siloxanen (C) Reste R⁸ überwiegend, bevorzugt ausschließlich, an Siliziumatome von Einheiten der Formel (X) gebunden, bei denen die Summe k+l+m gleich 3 ist.

Bevorzugt handelt es sich bei Komponente (C) um Siloxane bestehend aus Einheiten ausgewählt aus solchen der Formeln

R⁸ₖR⁹ₗR¹⁰ₘ(R¹¹O)ₙSiO_{1/2} mit (k+l+m+n) = 3 (XI),

R⁹ₗR¹⁰ₘ(R¹¹O)SiO_{2/2} mit (l+m) = 1 (XIIa),

R⁹ₗR¹⁰ₘSiO_{2/2} mit (l+m) = 2 (XIIb),

R⁹ₗR¹⁰ₘ(R¹¹O)ₙSiO_{3/2} mit (l+m+n) = 1 (XIII)

und

SiO_{4/2} (V),

wobei R⁸, R⁹, R¹⁰, R¹¹, k, l, m und n eine der oben angegebenen Bedeutungen hat,
mit der Maßgabe, dass die Siloxane (C) mindestens zwei Reste R⁸ pro Molekül aufweisen, pro Molekül mindestens ein Rest R¹⁰ anwesend ist und mindestens eine Einheit der Formel (XIII) und/oder (V) anwesend ist.

Die erfindungsgemäß eingesetzten Siloxane (C) enthalten bevorzugt mindestens 5 mol-% Einheiten der Formel (XI), mindestens 30 mol-% Einheiten der Formel (XIII) und höchstens 20 mol-% Einheiten der Formel (V).

Besonders bevorzugt handelt es sich bei Komponente (C) um Siloxane bestehend aus mindestens einer Einheit ausgewählt aus R⁹₃SiO_{1/2}-, R⁸R⁹₂SiO_{1/2}- , R⁹₂R¹⁰SiO_{1/2}-, R⁹R¹⁰₂SiO_{1/2}- , R⁸R⁹R¹⁰SiO_{1/2}- und R⁸R¹⁰₂SiO_{1/2}-Einheiten sowie mindestens einer Einheit ausgewählt aus R¹⁰SiO_{3/2}-, (R¹¹O)SiO_{3/2}- und R⁹SiO_{3/2}-Einheiten, sowie gegebenenfalls Einheiten ausgewählt aus R⁹₂SiO_{2/2}-, R⁹R¹⁰SiO_{2/2}-, R¹⁰₂SiO_{2/2}-, R⁹₂(R¹¹O)SiO_{1/2}-, R⁹R¹⁰(R¹¹O)SiO_{1/2}-, R⁹(R¹¹O)SiO_{2/2}- und R¹⁰(R¹¹O)SiO_{2/2}-Einheiten, wobei R⁸, R⁹, R¹⁰ und R¹¹ eine der oben angegebenen Bedeutungen hat,
mit der Maßgabe, dass pro Molekül mindestens zwei Reste R⁸ sowie mindestens ein Rest R¹⁰ anwesend sind und die gegebenenfalls enthaltenen Einheiten R⁹₂SiO_{2/2}-, R⁹R¹⁰SiO_{2/2}- und R¹⁰₂SiO_{2/2}- sowohl statistisch verteilt wie blockweise in der Komponente (C) vorliegen können.

Die erfindungsgemäß eingesetzten Harze (C) weisen bevorzugt keine Reste (OR¹¹) auf. Falls sie jedoch, z.B. herstellungsbedingt, Reste (OR¹¹) aufweisen, handelt es sich um Mengen von bevorzugt ≤ 5 Gew.-%, besonders bevorzugt ≤ 5000 Gew.-ppm, insbesondere ≤ 1000 Gew.-ppm.

Der molare Anteil an Resten R⁸ an der Gesamtzahl der Si-gebundenen Reste beträgt im Siloxan (C) bevorzugt 0,1 bis 50 %, besonders bevorzugt 0,1 bis 40 %, insbesondere 1 bis 30 %. Die Bestimmung erfolgt dabei bevorzugt mittels ²⁹Si-NMR-Spektroskopie.

Der molare Anteil der mindestens einen aromatischen Rest R¹⁰ tragenden Siliziumatome zur Gesamtanzahl der Siliziumatome im Siloxan (C) beträgt vorzugsweise mindestens 30 %, bevorzugt 40 % bis 80 %, insbesondere 50 % bis 75 %.

Bevorzugt bestehen die erfindungsgemäß eingesetzten Siloxane (C) aus 3 bis 1 000 Siloxyeinheiten, besonders bevorzugt aus 8 bis 500 Einheiten, insbesondere aus 8 bis 100 Einheiten.

Bevorzugte Beispiele für Komponente (C) sind Siloxane bestehend aus mindestens einer Einheit ausgewählt aus Me₃SiO_{1/2}-, ViMe₂SiO_{1/2}-, Me₂PhSiO_{1/2}-, MePh₂SiO_{1/2}- und ViMePhSiO_{1/2}-Einheiten sowie mindestens einer Einheit ausgewählt aus PhSiO_{3/2}-, HOSi-O_{3/2}- und MeSiO_{3/2}-Einheiten sowie gegebenenfalls Einheiten ausgewählt aus Me₂SiO_{2/2}-, MePhSiO_{2/2}-, Ph₂SiO_{2/2}-, Me₂(MeO)SiO_{1/2}-, Me₂(EtO)SiO_{1/2}-, Me₂(HO)SiO_{1/2}-, MePh(MeO)SiO_{1/2}-, MePh(EtO)SiO_{1/2}-, MePh(HO)SiO_{1/2}-, Ph(MeO)SiO_{2/2}-, Ph(EtO)SiO_{2/2}- und Ph(HO)SiO_{2/2}-Einheiten mit Me gleich Methylrest, Et gleich Ethylrest, Vi gleich Vinylrest und Ph gleich Phenylrest,
mit der Maßgabe, dass pro Molekül mindestens 2 Vinylreste und mindestens ein Phenylrest anwesend sind und die gegebenenfalls enthaltenen Einheiten R⁹₂SiO_{2/2}-, R⁹R¹⁰SiO_{2/2}- und R¹⁰₂SiO_{2/2}- sowohl statistisch verteilt wie blockweise in der Komponente (C) vorliegen können.

Siloxane (C) haben ein mittleres Molekulargewicht Mw von vorzugsweise mindestens 600 g/mol, bevorzugt mindestens 700 g/mol, besonders bevorzugt mindestens 800 g/mol, insbesondere zwischen 900 und 10 000 g/mol, wobei die Polydispersität vorzugsweise höchstens 20, bevorzugt höchstens 15, besonders bevorzugt höchstens 10, insbesondere höchstens 8, ist.

Die erfindungsgemäß eingesetzten Siloxanharze (C) können bei 23°C und 1000 hPa sowohl fest als auch flüssig sein, wobei die flüssigen Siloxanharze (C) niedrigviskos bis hochviskos sein können und die Siloxane (C) bevorzugt niedrigviskos sind.

Falls die erfindungsgemäß eingesetzten Siloxanharze (C) niedrigviskos sind, beträgt die Viskosität bevorzugt zwischen 10 und 20 000 mPas, besonders bevorzugt zwischen 20 und 15 000 mPas, insbesondere zwischen 30 und 10 000 mPas, ganz besonders bevorzugt zwischen 40 und 8 000 mPas, jeweils bei 25°C.

In einer ebenfalls bevorzugten Ausführungsform handelt es sich bei Siloxanen (C) um bei 23°C hochviskose bis standfeste Massen mit noch klebriger Oberfläche und Glasüberganstemperaturen von mehr als -20°C oder um klebfreie Festkörper mit einer Glasübergangstemperatur von mehr als 25°C.

Die erfindungsgemäßen Zusammensetzungen enthalten Komponente (C) in Mengen von vorzugsweise 1 bis 200 Gewichtsteilen, besonders bevorzugt 10 bis 150 Gewichtsteilen, insbesondere 20 bis 100 Gewichtsteilen, jeweils bezogen auf 100 Gewichtsteile Komponente (A).

Die erfindungsgemäß eingesetzten Siloxane (C) sind nach in der Chemie gängigen Verfahren herstellbar.

Als Komponente (D), der die Anlagerung von Si-gebundenem Wasserstoff an aliphatische Kohlenstoff-Kohlenstoff-Mehrfachbindung (Hydrosilylierung) fördert, können in den erfindungsgemäßen Zusammensetzungen alle bisher bekannten Hydrosilylierungskatalysatoren verwendet werden.

Beispiele für Komponente (D) sind metallisches und feinverteiltes Platin, das sich auf Trägern, wie Siliciumdioxid, Aluminiumoxid oder Aktivkohle befinden kann, Verbindungen oder Komplexe von Platin, wie Platinhalogenide, z.B. PtCl₄, H₂PtCl₆.6H₂O, Na₂PtCl₄.4H₂O, Platin-Olefin-Komplexe, Platin-Alkohol-Komplexe, Platin-Alkoholat-Komplexe, Platin-Ether-Komplexe, Platin-Aldehyd-Komplexe, Platin-Keton-Komplexe, einschließlich Umsetzungsprodukten aus H₂PtCl₆.6H₂O und Cyclohexanon, Platin-Vinylsiloxankomplexe, insbesondere Platin-Divinyltetramethyldisiloxankomplexe mit oder ohne Gehalt an nachweisbarem anorganisch gebundenem Halogen, Bis-(gamma-picolin)-platindichlorid, Trimethylendipyridinplatindichlorid, Dicyclopentadienplatindichlorid, Dimethylsulfoxydethylenplatin-(II)-dichlorid sowie Umsetzungsprodukte von Platintetrachlorid mit Olefin und primärem Amin oder sekundärem Amin oder primärem und sekundärem Amin, wie das Umsetzungsprodukt aus in 1-Octen gelöstem Platintetrachlorid mit sec.-Butylamin, oder Ammonium-Platinkomplexe, Rhodium, Palladium, Ruthenium und Iridium sowie deren Verbindungen und Komplexe.

Für licht- oder UV-härtende Zusammensetzungen können beispielsweise Alkylplatinkomplexe wie Derivate von Cyclopentadienyltrimethylplatin(IV), Cyclooctadienyldimethylplatin(II) oder Diketonatokomplexe wie zum Beispiel Bisacetylacetonatoplatin(II) verwendet werden, um die Additionsreaktion mit Hilfe von Licht zu starten.

Diese Verbindungen können in einer Harzmatrix eingekapselt sein.

Vorzugsweise werden als erfindungsgemäß gegebenenfalls eingesetzter Katalysator (D) Platin, dessen Verbindungen oder Komplexe verwendet, besonders bevorzugt Platin-Divinyltetramethyldisiloxankomplexe.

In einer anderen bevorzugten erfindungsgemäßen Ausführung wird der gegebenenfalls eingesetzte Katalysator (D) ausgewählt aus der Gruppe bestehend aus Cyclopentadienyltrimethylplatin (IV) und dessen Derivaten.

Falls Katalysator (D) eingesetzt wird, richtet sich die Menge nach der gewünschten Vernetzungsgeschwindigkeit und der jeweiligen Verwendung sowie ökonomischen Gesichtspunkten. Die erfindungsgemäßen Zusammensetzungen enthalten bevorzugt Katalysator (D). Die erfindungsgemäßen Zusammensetzungen enthalten Katalysatoren (D) in solchen Mengen, dass ein Platingehalt von vorzugsweise 0,05 bis 500 Gewichts-ppm (= Gewichtsteile je Million Gewichtsteile), besonders bevorzugt 0,5 bis 100 Gewichts-ppm, insbesondere 1 bis 50 Gewichts-ppm, jeweils bezogen auf das Gesamtgewicht der vernetzbaren Zusammensetzung, resultiert.

Zusätzlich zu den eingesetzten Komponenten (A), (B), gegebenenfalls (C) und gegebenenfalls (D) können die erfindungsgemäßen Zusammensetzungen alle weiteren Stoffe enthalten, die auch bisher in durch Additionsreaktion vernetzbaren Massen eingesetzt wurden und die unterschiedlich sind zu Komponenten (A), (B), (C) und (D), wie z.B. Füllstoffe (E), Haftvermittler (F), Inhibitoren (G), Weichmacher (H), Additive (K) und organische Lösungsmittel (L).

Bei den in den erfindungsgemäßen Zusammensetzungen gegebenenfalls eingesetzten Füllstoffen (E) kann es sich um beliebige, bisher bekannte Füllstoffe handeln.

Beispiele für Füllstoffe (E) sind nicht verstärkende Füllstoffe, also Füllstoffe mit einer BET-Oberfläche von vorzugsweise bis zu 50 m²/g, wie Quarz, Diatomeenerde, Calciumsilikat, Zirkoniumsilikat, Talkum, Kaolin, Zeolithe, Metalloxidpulver, wie Aluminium-, Titan-, Eisen- oder Zinkoxide bzw. deren Mischoxide, Bariumsulfat, Calciumcarbonat, Gips, Siliciumnitrid, Siliciumcarbid, Bornitrid, Glas- und Kunststoffpulver, wie Polyacrylnitrilpulver; verstärkende Füllstoffe, also Füllstoffe mit einer BET-Oberfläche von mehr als 50 m²/g, wie pyrogen hergestellte Kieselsäure, gefällte Kieselsäure, gefällte Kreide, Ruß, wie Furnace- und Acetylenruß und Silicium-Aluminium-Mischoxide großer BET-Oberfläche; Aluminiumtrihydroxid, hohlkugelförmiger Füllstoffe, wie keramische Mikrokugel, elastische Kunststoffkugeln, Glaskugeln oder faserförmige Füllstoffe. Die genannten Füllstoffe können hydrophobiert sein, beispielsweise durch die Behandlung mit Organosilanen bzw. -siloxanen oder mit Stearinsäure oder durch Veretherung von Hydroxylgruppen zu Alkoxygruppen.

Bevorzugt handelt es sich bei den gegebenenfalls eingesetzten Füllstoffen (E) um verstärkende Füllstoffe mit einer BET-Oberfläche von mehr als 50 m²/g, wie pyrogen hergestellter Kieselsäure.

Gegebenenfalls eingesetzte Füllstoffe (E) haben einen Feuchtigkeitsgehalt von bevorzugt unter 1 Gew.-%, besonders bevorzugt von unter 0,5 Gew.-%.

Falls die erfindungsgemäßen Zusammensetzungen Füllstoffe (E) enthalten, handelt es sich um Mengen von vorzugsweise 1 bis 40 Gewichtsteilen, besonders bevorzugt 5 bis 35 Gewichtsteilen, insbesondere 10 bis 30 Gewichtsteilen, jeweils bezogen auf 100 Gewichtsteile Bestandteil (A).

In einer weiteren erfindungsgemäßen Ausführung enthalten die Zusammensetzungen 0,01 bis 3,0 Gewichtsteile, bevorzugt 0,05 bis 1,0 Gewichtsteile, einer pyrogen hergestellten Kieselsäure mit einer Oberfläche von mehr als 50 m²/g zur Kontrolle der rheologischen Eigenschaften.

Die erfindungsgemäßen Zusammensetzungen enthalten bevorzugt keine Füllstoffe (E).

Bei den in den erfindungsgemäßen Zusammensetzungen gegebenenfalls eingesetzten Haftvermittler (F) kann es sich um beliebige, bisher bekannte Haftvermittler handeln.

Beispiele für Haftvermittler (F) sind Silane oder Siloxane mit Methacryloxy- oder Epoxyfunktionen, wobei Silane oder Siloxane mit Epoxyfunktionen bevorzugt sind.

Falls die erfindungsgemäßen Zusammensetzungen Haftvermittler (F) enthalten, handelt es sich um Mengen von vorzugsweise 0,01 bis 10 Gewichtsteilen, besonders bevorzugt 0,05 bis 5 Gewichtsteilen, insbesondere 0,1 bis 3 Gewichtsteilen, jeweils bezogen auf 100 Gewichtsteile Bestandteil (A). Die erfindungsgemäßen Zusammensetzungen enthalten bevorzugt Haftvermittler (F).

Bei den gegebenenfalls ein gesetzten Inhibitoren (G) kann es sich um beliebige auf dem Gebiet der additionsvernetzenden Zusammensetzungen bekannte Inhibitoren und Stabilisatoren handeln, die der gezielten Einstellung der Verarbeitungszeit und Vernetzungsgeschwindigkeit der vernetzbaren Zusammensetzungen dienen. Beispiele gebräuchlicher Inhibitoren sind acetylenisch ungesättigte Alkohole, wie 3-Methyl-1-butin-3-ol, 1-Ethinylcyclohexan-1-ol, 3,5-Dimethyl-1-hexin-3-ol und 3-Methyl-1-pentin-3-ol, Polymethylvinylcyclosiloxane, wie 1,3,5,7-Tetramethyl-1,3,5,7-tetravinylcyclotetrasiloxan, lineare Vinylsiloxane wie 1,1,3,3,-Tetramethyl-1,3-divinyl-disiloxan und (Vinyl-methyl)-siloxy-dimethyl-siloxy Copolymere, Trialkylcyanurate, Alkylmaleate, wie Diallylmaleat und Dimethylmaleat, Alkylfumarate, wie Diethylfumarat und Diallylfumarat, β-Ketoverbindungen, wie Acetylacetonat, organische Hydroperoxide, wie Cumolhydroperoxid, tert.-Butylhydroperoxid und Pinanhydroperoxid, organische Peroxide, organische Sulfoxide, organische Amine und Amide, Phosphine und Phosphite, Nitrile, Triazole wie Benzotriazol, Diaziridine und Oxime.

Falls die erfindungsgemäßen Zusammensetzungen Inhibitoren (G) enthalten, handelt es sich um Mengen von vorzugsweise 0,01 bis 20 Gewichtsteilen, besonders bevorzugt 0,01 bis 10 Gewichtsteilen, insbesondere 0,05 bis 2 Gewichtsteilen, jeweils bezogen auf 100 Gewichtsteile Bestandteil (A). Die erfindungsgemäßen Zusammensetzungen enthalten bevorzugt Inhibitoren (G).

Bei den gegebenenfalls eingesetzten Weichmachern (H) kann es sich um beliebige auf dem Gebiet der additionsvernetzenden Massen bekannte Weichmacher handeln, wie z.B Trialkylsilylterminierte, lineare oder verzweigte Siloxane oder cyclische Siloxane, die frei von aliphatisch ungesättigten Resten und von Silizium gebundenem Wasserstoff sind, wobei lineare und cyclische Siloxane bevorzugt sind.

Die erfindungsgemäßen Zusammensetzungen enthalten bevorzugt keinen Weichmacher (H).

Beispiele für Additive (K) sind lösliche Farbstoffe, anorganische und organische Pigmente, Fluoreszenzfarbstoffe, Fungicide, Duftstoffe, Dispergierhilfsmittel, rheologische Additive, Korrosionsinhibitoren, Oxidationsinhibitoren, Lichtschutzmittel, Hitzestabilisatoren, flammabweisend machende Mittel, Mittel zur Beeinflussung der elektrischen Eigenschaften und Mittel zur Verbesserung der Wärmeleitfähigkeit, Mittel zur Lichtstreuung, wobei anorganische Pigmente, organische Pigmente oder Fluoreszenzfarbstoffe bevorzugt sind.

Falls die erfindungsgemäßen Zusammensetzungen Additive (K) enthalten, handelt es sich um Mengen von vorzugsweise 0,1 bis 30 Gewichtsteilen, besonders bevorzugt 1 bis 20 Gewichtsteilen, insbesondere 5 bis 15 Gewichtsteilen, jeweils bezogen auf 100 Gewichtsteile Bestandteil (A).

Beispiele für Lösungsmittel (L) sind aromatische Lösungsmittel, wie Toluol, Xylol, Ethylbenzol oder Mischungen derselben sowie organische Ester der Essigsäure wie Ethylacetat, Butylacetat, Methoxypropylacetat und Kohlenwasserstoffe bzw. deren Gemische wie beispielsweise handelsübliche Isoparaffinmischungen, wobei aromatische Lösungsmittel oder Isoparaffinmischungen bevorzugt sind.

Falls die erfindungsgemäßen Zusammensetzungen Lösungsmittel (L) enthalten, handelt es sich um Mengen von vorzugsweise 0,1 bis 50 Gewichtsteilen, besonders bevorzugt 1 bis 30 Gewichtsteilen, insbesondere 5 bis 20 Gewichtsteilen, jeweils bezogen auf 100 Gewichtsteile Bestandteil (A). Die erfindungsgemäßen Zusammensetzungen enthalten bevorzugt keine Lösungsmittel (L).

Bei den erfindungsgemäßen Zusammensetzungen handelt es sich bevorzugt um solche enthaltend
(A) Siloxane aus Einheiten der Formel (I),
   gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
   gegebenenfalls (E) Füllstoffe,
   gegebenenfalls (F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

In einer weiteren bevorzugten Ausführungsform handelt es sich bei den erfindungsgemäßen Zusammensetzungen um solche enthaltend
(A) Siloxane aus Einheiten der Formel (I),
   gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
   gegebenenfalls (E) Füllstoffe,
(F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

Bei den erfindungsgemäßen Zusammensetzungen handelt es sich besonders bevorzugt um solche enthaltend
(A) Siloxane aus Einheiten der Formel (I),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
(F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

In einer weiteren bevorzugten Ausführungsform handelt es sich bei den erfindungsgemäßen Zusammensetzungen um solche enthaltend
(A) Siloxane aus Einheiten der Formel (I),
(B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
(F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

In einer weiteren bevorzugten Ausführungsform handelt es sich bei den erfindungsgemäßen Zusammensetzungen um solche enthaltend
(A) Siloxane aus Einheiten der Formel (I),
   gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator, ausgewählt aus der Gruppe der Platin-Vinylsiloxan Komplexe,
   gegebenenfalls (E) Füllstoffe,
(F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

In einer weiteren bevorzugten Ausführungsform handelt es sich bei den erfindungsgemäßen Zusammensetzungen um solche enthaltend
(A) Siloxane aus Einheiten der Formel (I),
   gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator, ausgewählt aus der Gruppe bestehend aus Cyclopentadienyltrimethylplatin(IV)und dessen Derivaten,
   gegebenenfalls (E) Füllstoffe,
(F) Haftvermittler,
   gegebenenfalls (G) Inhibitoren,
   gegebenenfalls (H) Weichmacher,
   gegebenenfalls (K) Additive und
   gegebenenfalls (L) Lösungsmittel.

Die erfindungsgemäßen Zusammensetzungen enthalten außer den Komponenten (A) bis (L) vorzugsweise keine weiteren Bestandteile.

Bei den erfindungsgemäß eingesetzten Komponenten kann es sich jeweils um eine Art einer solchen Komponente wie auch um ein Gemisch aus mindestens zwei Arten einer jeweiligen Komponente handeln.

Die erfindungsgemäßen Zusammensetzungen sind bevorzugt fließfähig, mit handelsüblichen Dosieranlagen verarbeitbar und nach Vulkanisation farblos und transparent.

Die erfindungsgemäßen Zusammensetzungen können - insbesondere je nach Viskosität der Bestandteile sowie Füllstoffgehalt - niedrigviskos und gießbar sein, eine pastöse Konsistenz aufweisen, pulverförmig sein oder auch geschmeidige, hochviskose Massen darstellen, wie dies bekanntermaßen bei den in Fachkreisen häufig als RTV-1, RTV-2, LSR und HTV bezeichneten Zusammensetzungen der Fall sein kann. Bevorzugt sind die Zusammensetzungen niedrigviskos und können Eigenschaften der in Fachkreisen als RTV-2 bezeichneten Zusammensetzungen entsprechen.

Die Herstellung der erfindungsgemäßen Zusammensetzungen kann nach beliebiger und an sich bekannter Art und Weise erfolgen, wie etwa nach Methoden und Mischverfahren, wie sie zur Herstellung von additionsvernetzenden Zusammensetzungen üblich sind.

Ein weiterer Gegenstand der vorliegenden Erfindung ist ein Verfahren zur Herstellung der erfindungsgemäßen Zusammensetzungen durch Mischen der einzelnen Komponenten in beliebiger Reihenfolge.

Dieses Vermischen kann bei Raumtemperatur und dem Druck der umgebenden Atmosphäre, also etwa 900 bis 1100 hPa, erfolgen. Falls erwünscht, kann dieses Vermischen aber auch bei höheren Temperaturen erfolgen, z.B. bei Temperaturen im Bereich von 30 bis 130°C. Weiterhin ist es möglich, zeitweilig oder ständig unter vermindertem Druck zu mischen, wie z.B. bei 30 bis 500 hPa Absolutdruck, um flüchtige Verbindungen und/oder Luft zu entfernen.

Wird in einer Ausführungsform als Komponente (D) ein Katalysator eingesetzt, durch den die Additionsreaktion mit Hilfe von Licht gestartet wird, so erfolgt das erfindungsgemäße Vermischen erfolgt bevorzugt unter Ausschluss von Licht mit einem Wellenlängenbereich von 190 bis 500 nm.

Das erfindungsgemäße Verfahren kann kontinuierlich oder diskontinuierlich durchgeführt werden.

In einer bevorzugten Ausführungsform des erfindungsgemäßen Verfahrens werden Katalysator (D) mit einer Mischung aus (A), gegebenenfalls (B), (C), gegebenenfalls (G) und gegebenenfalls (F) gleichmäßig vermischt. Der erfindungsgemäß eingesetzte Katalysator (D) kann dabei als Substanz oder als Lösung - in einem geeigneten Lösungsmittel gelöst - oder als sogenannter Batch - gleichmäßig mit einer geringen Menge eines Siloxans wie z.B. (C) oder, sofern in der Ausführungsform eingesetzt, Komponente (B) oder Komponente (G)vermischt - eingearbeitet werden.

Für das Vermischen können alle bislang bekannten, geeigneten Aggregate verwendet werden, wie z.B. Planetenmischer oder Dissolver.

Bei den erfindungsgemäßen Zusammensetzungen kann es sich sowohl um Einkomponenten-Siliconzusammensetzungen als auch Zweikomponenten-Siliconzusammensetzungen handeln. In letzterem Fall wird die den Katalysator (D) enthaltende Komponente hergestellt, indem der Katalysator (D) mit (C) und gegebenenfalls (B), gegebenenfalls (G) und gegebenenfalls (F) gleichmäßig vermischt wird, während die den Silizium-gebundenen Wasserstoff enthaltende Komponente entweder nur aus (A) besteht oder durch gleichmäßiges Vermischen der Komponente (A) mit gegebenenfalls (B), (C), gegebenfalls (G) und gegebenfalls (F) hergestellt wird.

Wenn es sich bei den erfindungsgemäßen Zusammensetzungen um Einkomponenten-Siliconzusammensetzungen handelt, wird beim Vermischen der Komponenten die Temperatur der Zusammensetzungen bevorzugt unter 50°C, besonders bevorzugt bei 10 bis 30 °C, gehalten, um ein vorzeitiges Einsetzen der Vernetzungsreaktion zu verhindern.

Die erfindungsgemäßen durch Anlagern von Si-gebundenem Wasserstoff an aliphatische Mehrfachbindung vernetzbaren Massen können unter den gleichen Bedingungen vernetzen gelassen werden, wie die bisher bekannten durch Hydrosilylierungsreaktion vernetzbaren Zusammensetzungen.

Die Verarbeitung der erfindungsgemäßen Zusammensetzungen erfolgt bevorzugt mit handelsüblichen Misch- und Dosieranlagen bei Temperaturen bevorzugt zwischen 15 und 50°C bevorzugt durch Dosierung in offene Formen oder direkt auf die gewünschten Bauteile und anschließende Vernetzung bei dem Druck der umgebenden Atmosphäre also etwa 900 bis 1100 hPa.

Vorzugsweise erfolgt die Vernetzung thermisch.

Insbesondere erfolgt die Vernetzung bei Anwesenheit eines die Additionsreaktion fördernden Katalysators und Aktivierung durch Erwärmen.

Vorzugsweise wird die Vernetzung bei einer Temperatur von 0 bis 200°C, insbesondere bei 10 bis 150°C, durchgeführt. Die Vernetzungszeiten liegen vorzugsweise zwischen 1 Minute und 10 Stunden, besonders bevorzugt zwischen 10 Minuten und 5 Stunden, insbesondere zwischen 30 Minuten und 3 Stunden.

In einer anderen Ausführungsform erfolgt die Vernetzung bei Drücken wie sie in einer Spritzgussmaschine üblich sind, also ca. 200 000 hPa. Die Temperaturen liegen bei dieser Ausführungsform vorzugsweise zwischen 50 und 200°C, insbesondere zwischen 120 und 180°C. Die Vernetzungszeiten liegen zwischen 1 Sekunde und 10 Minuten, vorzugsweise zwischen 5 Sekunden und 2 Minuten.

In einer weiteren Ausführungsform, bei der die erfindungsgemäße Zusammensetzung als Komponente (D) einen Katalysator enthält, durch den die Additionsreaktion mit Hilfe von Licht gestartet wird, erfolgt die Vernetzung der Zusammensetzung vorzugsweise nach Bestrahlen mit Strahlung im UV-Vis Bereich des elektromagnetischen Spektrums, also zwischen 190 und 800 nm, bevorzugt zwischen 250 und 500 nm. Als Lichtquellen können alle bekannten entsprechenden Lichtquellen und Kombinationen von Lichtquellen mit Filtern verwendet werden, wie z.B. Quecksilberdampflampen, dotierte Quecksilberdampflampen, Xenon-Entladungslampen, andere Entladungslampen, LED Lichtquellen oder Laser.

Ein weiterer Gegenstand der vorliegenden Erfindung sind Formkörper hergestellt durch Vernetzung der erfindungsgemäßen Zusammensetzungen.

Bei den erfindungsgemäßen Formkörpern kann es sich um beliebige Formkörper handeln, wie etwa Dichtungen, Pressartikel, extrudierte Profile, extrudierte Stränge, Beschichtungen, Imprägnierungen, Verguss, Linsen, Artikel zur Lichtleitung, Prismen, polygone Strukturen, Laminat- oder Klebschichten, bevorzugt um Verguss, Linsen und Artikel zur Lichtleitung.

Die erfindungsgemäßen Formkörper weisen Härten bevorzugt im Bereich von Shore A 20 bis Shore D 80, besonders bevorzugt im Bereich von Shore A 70 bis Shore D 80, auf. Die erfindungsgemäßen Formkörper sind bevorzugt farblos und hochtransparent mit Transmissionen vorzugsweise > 90 % zwischen 400 und 800 nm, gemessen durch UV-Vis Spektroskopie. Die erfindungsgemäßen Formkörper weisen bevorzugt geringe, besonders bevorzugt keine, Gelbfärbung bei thermischer Belastung auf. Erfindungsgemäße Formkörper weisen Brechungsindizes n_{D}²⁵ von vorzugsweise > 1,43, bevorzugt > 1,46, besonders bevorzugt > 1,50, insbesondere > 1,52 auf.

Die erfindungsgemäßen Zusammensetzungen sowie die erfindungsgemäß daraus hergestellten Vernetzungsprodukte können für alle Zwecke eingesetzt werden, für die auch bisher zu Elastomeren vernetzbare Siloxanzusammensetzungen bzw. Elastomere verwendet wurden. Dies umfasst beispielsweise die Siliconbeschichtung bzw. Imprägnierung beliebiger Substrate, die Herstellung von Formteilen, beispielsweise im Spritzgussverfahren, Vakuumextrusionsverfahren, Extrusionsverfahren, Formgießen und Formpressen, und Abformungen, die Verwendung als Dicht-, Einbett- und Vergussmassen.

Eine bevorzugte Verwendung der erfindungsgemäßen Zusammensetzung ist die Verwendung zum Verguss von optischen Halbleiterelementen wie LED. In einer bevorzugten Ausführungsform wird dabei die erfindungsgemäße Zusammensetzung z.B. mit einer üblichen Dosieranlage auf das Halbleiterelement dosiert und anschließend vulkanisiert. Dabei können unterschiedliche Chip-Designs der Halbleiterelemente (sogenannte LED packages) verwendet werden, wie SMD (surface mounted design) packages, COB (Chip on Board) packages, MCOB (Multiple Chip on Board) und andere.

Die erfindungsgemäßen Zusammensetzungen haben den Vorteil, dass sie leicht herzustellen sind.

Die erfindungsgemäßen Zusammensetzungen haben den Vorteil, dass sie sich durch eine sehr hohe Lagerstabilität und eine hohe Vernetzungsgeschwindigkeit auszeichnen.

Ferner haben die erfindungsgemäßen Zusammensetzungen den Vorteil, dass sie ein ausgezeichnetes Haftungsprofil aufweisen.

Des Weiteren haben die erfindungsgemäßen Zusammensetzungen den Vorteil, dass sie leicht zu verarbeiten sind.

Die erfindungsgemäßen Zusammensetzungen haben den Vorteil, dass sie eine einfache Variabilität aufweisen und gleichzeitig die oben gezeigten Anforderungen erfüllen.

Die erfindungsgemäßen Zusammensetzungen haben ferner den Vorteil, dass sie den Anforderung an Vergussmassen für LEDs erfüllen, gute Verarbeitbarkeit zeigen und zu optisch hochtransparenten Vulkanisaten ausgehärtet werden können.

Das erfindungsgemäße Verfahren zur Herstellung der Siloxanzusammensetzungen hat den Vorteil, dass es einfach in der Durchführung ist.

Optische Bauteile wie LEDs, die mit den erfindungsgemäßen Zusammensetzungen vergossen und die Zusammensetzungen anschließend vernetzen gelassen wurden, bestehen überraschenderweise vorzugsweise mindestens 100 Cyclen im Temperaturwechseltest, bevorzugt mindestens 300 Cyclen, insbesondere mindestens 500 Cyclen.

Optische Bauteile wie LEDs, die mit den erfindungsgemäßen Zusammensetzungen vergossen und die Zusammensetzungen anschließend vernetzen gelassen wurden, weisen vorteilhafterweise eine verbesserte Beständigkeit gegen schwefelhaltige Gase auf.

Optische Bauteile wie LEDs, die mit den erfindungsgemäßen Zusammensetzungen vergossen und die Zusammensetzungen anschließend vernetzen gelassen wurden, weisen vorteilhafterweise verbesserte Lichtausbeuten im Vergleich zum Stand der Technik vorteilhafterweise auf.

Sofern nicht anders angegeben, werden die nachstehenden Beispiele bei einem Druck der umgebenden Atmosphäre, also etwa bei 1000 hPa, und bei Raumtemperatur, also bei etwa 23°C, bzw. bei einer Temperatur, die sich beim Zusammengeben der Reaktanden bei Raumtemperatur ohne zusätzliche Heizung oder Kühlung einstellt, sowie bei einer relativen Luftfeuchtigkeit von etwa 50 % durchgeführt. Des Weiteren beziehen sich alle Angaben von Teilen und Prozentsätzen, soweit nichts anderes angegeben ist, auf das Gewicht.

Im vorliegenden Text werden Stoffe durch Angabe von Daten charakterisiert, die mittels instrumenteller Analytik erhalten werden. Die zugrundeliegenden Messungen werden entweder öffentlich zugänglichen Normen folgend durchgeführt oder nach speziell entwickelten Verfahren ermittelt. Um die Klarheit der mitgeteilten Lehre zu gewährleisten, sind die verwendeten Methoden hier angegeben:

### Viskosität:

Die Viskositäten werden, wenn nicht anders angegeben, an einem Rheometer MCR302 der Fa. Anton Paar, D-Ostfildern gemäß DIN EN ISO 3219 in Rotation mit einem Kegel-Platte Messsystem bestimmt. Die Messungen erfolgen im newtonschen Bereich der Proben. Bei nicht-newtonschem Verhalten der Probe wird die Scherrate mit angegeben. Falls nicht anders angegeben, gelten alle Viskositätsangaben bei 25°C und Normaldruck von 1013 mbar.

### Brechungsindex:

Die Brechungsindices werden im Wellenlängenbereich des sichtbaren Lichtes bestimmt, falls nicht anders angegeben bei 589 nm bei 25°C (n_{D}²⁵) und Normaldruck von 1013 mbar gemäß der Norm DIN 51423. Verwendet wurden Abbe Refraktometer der Firma A. Krüss Optronics, D-Hamburg und der Firma Atago, Japan, Typ DR-M2.

### Molekülzusammensetzungen:

Die Molekülzusammensetzungen werden mittels Kernresonanzspektroskopie bestimmt (zu Begrifflichkeiten siehe ASTM E 386: Hochauflösende magnetische Kernresonanzspektroskopie (NMR): Begriffe und Symbole), wobei der ¹H-Kern und der ²⁹Si-Kern vermessen wird.

### Beschreibung 1H-NMR Messung

| | |
|---|---|
| Solvent: | CDCl3, 99,8%d |
| Probenkonzentration: | ca. 50 mg / 1 ml CDC13 in 5 mm NMR-Röhrchen |

Messung ohne Zugabe von TMS, Spektrenreferenzierung von Rest-CHCl3 in CDCl3 auf 7,24 ppm

| | |
|---|---|
| Spektrometer: | Bruker Avance I 500 oder Bruker Avance HD 500 |
| Probenkopf: | 5 mm BBO-Probenkopf oder SMART-Probenkopf (Fa. Bruker) |

### Messparameter:

Pulprog = zg30
TD = 64k
NS = 64 bzw. 128 (abhängig von der Empfindlichkeit des Probenkopfes)
SW = 20,6 ppm
AQ = 3,17 s
D1 = 5 s
SFO1 = 500,13 MHz
O1 = 6,175 ppm

### Processing-Parameter:

SI = 32k
WDW = EM
LB = 0,3 Hz

Je nach verwendetem Spektrometertyp sind evtl. individuelle Anpassungen der Messparameter erforderlich.

### Beschreibung 29Si-NMR Messung

| | |
|---|---|
| Solvent: | C6D6 99,8%d/CCl4 1:1 v/v mit 1Gew% Cr(acac)3 als Relaxationsreagenz |
| Probenkonzentration: | ca. 2 g / 1,5 ml Solvent in 10 mm NMR-Röhrchen |
| Spektrometer: | Bruker Avance 300 |
| Probenkopf: | 10 mm 1H/13C/15N/29Si glasfreier QNP-Probenkopf (Fa. Bruker) |

### Messparameter:

Pulprog = zgig60
TD = 64k
NS = 1024 (abhängig von der Empfindlichkeit des Probenkopfes)
SW = 200 ppm
AQ = 2,75 s
D1 = 4 s
SFO1 = 300,13 MHz
O1 = -50 ppm

### Processing-Parameter:

SI = 64k
WDW = EM
LB = 0,3 Hz

Je nach verwendetem Spektrometertyp sind evtl. individuelle Anpassungen der Messparameter erforderlich.

### Molekulargewichtsverteilungen:

Molekulargewichtsverteilungen werden als Gewichtsmittel Mw und als Zahlenmittel Mn bestimmt, wobei die Methode der Gelpermeationschromatographie (GPC bzw. Size Exclusion Chromatographie (SEC)) Anwendung findet mit Polystyrol Standard und Brechungsindexdetektor (RI-Detektor). Wo nicht anders ausgewiesen wird THF als Eluent verwendet und DIN 55672-1 angewendet. Die Polydispersität ist der Quotient Mw/Mn.

### Glasübergangstemperaturen:

Die Glasübergangstemperatur wird nach Dynamischer Differenzkalorimetrie (Differential Scanning Calorimetry, DSC) nach DIN 53765, in einem gelochten Tiegel mit einer Aufheizrate von 10 K/min bestimmt an einem Kalorimeter DSC 1 der Fa. Mettler Toledo, CH-Greifensee.

### Shore Härten:

Die Härte Shore A und die Härte Shore D werden nach DIN (Deutsche Industrie Norm) 53505 (Ausgabe August 2000) an Härte-Messgeräten der Firma Bareiss, D-Oberdischingen (Typ HPE II Shore A bzw. Shore D) bestimmt.

### Temperaturwechseltest:

Für die Temperaturwechseltests an Vulkanisaten bzw. funktionsfähigen, vergossenen Bauteilen, werden Geräte der Firma Espec, Japan verwendet (Thermal Shock Chamber TSE-11, Elevator Type). Wenn nicht anders angegeben, liegt die untere Temperatur der Thermozyklen bei -45 °C und die obere Temperatur der Thermozyklen bei 125 °C. Bei jeder Temperatur werden die Proben 15 Minuten gehalten. Ein Zyklus dauert also 30 Minuten.

### Beständigkeit gegen Schwefel-haltige Gase:

Auf den mit Wasser bedeckten Boden eines Glasgefäßes wird eine Schale mit K₂S gestellt, so dass das K₂S nicht mit dem Wasser in Berührung kommt. Die funktionsfähigen Bauteile (z.B. LEDs) werden im Gasraum oberhalb der Schale mit K₂S platziert und das Gefäß verschlossen. Das Glasgefäß wird in einem Wasserbad auf 85 °C erwärmt. Messungen an den Bauteilen werden typischerweise nach Intervallen von 8 h durchgeführt. Für die Messungen wird wie folgt vorgegangen: zunächst wird die Lichtausbeute der unbehandelten LED gemessen. Dann werden die LED wie oben beschrieben den Bedingungen in dem oben beschriebenen Glasgefäß mit K₂S ausgesetzt. Anschließend wird wieder die Lichtausbeute der LED gemessen und mit dem Ausgangswert verglichen. Es können dann weitere Zyklen der Exposition im Glasgefäß und anschließender Messung der Lichtausbeute folgen.

### Lichtausbeute (light efficiency):

Die Lichtausbeuten werden mit einem Gerät der Firma Instrument Systems, Japan, Typ Compact Array Spectrometer CAS 140CT an einer Ulbrichtkugel Typ ISP 250 (250 mm Innendurchmesser) entsprechend CIE 127 für Lichtstrommessungen an LED durchgeführt.

Im Folgenden bedeuten
Ph einen Phenylrest = C₆H₅-,
Vi einen Vinylrest = CH₂=CH- und
Me einen Methylrest = CH₃-.

### Herstellung eines Si-H und Si-Vi bifunktionellen Phenylharzes mit ausgeglichener Funktionalität (A1)

Als Apparatur für die Ausführung der Reaktion wird ein 114-Halsglaskolben mit Auslauf, mit KPG-Rührer, Intensivkühler und Dosiergefäß (Tropftrichter) verwendet. In den Glaskolben werden 300 g vollentsalztes Wasser eingefüllt. In einem 11 Becherglas werden 60 g (0,5 mol) Vinyldimethylchlorsilan (Molekulargewicht 120,5 g/mol), 135 g (0,63 mol) Phenyltrichlorsilan (Molekulargewicht 211,5 g/mol) und 30 g (0,31 mol) Dimethylchlorsilan (Molekulargewicht 94 g/mol) mit einem Magnetrührer vermischt und anschließend in das Dosiergefäß überführt.

Die Chlorsilanmischung wird über 2 Stunden in die Wasservorlage dosiert, wobei die Temperatur von 21,3°C auf 46,0°C ansteigt. Nach beendeter Dosierung wird noch 1 Stunde ohne Zuheizen oder Kühlen nachgerührt. Danach werden weitere 19 g (0,2 mol) Dimethylchlorsilan in das Dosiergefäß gegeben und über einen Zeitraum von 10 Minuten zugegeben. Nach beendeter Dosierung beträgt die Temperatur 32°C. Man rührt 20 Minuten nach. Es wird eine zweiphasige Reaktionsmischung erhalten. Die untere Phase ist die salzsaure Wasserphase, die aus dem Kolben abgelassen wird. Man gibt in die verbliebene Produktphase 500 g vollentsalztes Wasser zu und heizt auf 60°C auf. Bei dem nun erhaltenen zweiphasigen Gemisch ist die obere Phase die Wasserphase, die wiederum abgetrennt wird. Man wiederholt den Waschvorgang insgesamt dreimal. Sodann werden zur Produktphase 15 g Filterhilfe Seitz EF zugegeben, 15 Minuten gerührt und mit einer Druckfilternutsche über eine Seitz K 100 Filterplatte filtriert.

Das Filtrat wird am Rotationsverdampfer bei 160°C und 10 mbar Druck 2 Stunden lang ausgeheizt. Man erhält 110 g eines leicht trüben Produktes mit einer Viskosität von 133 mm²/s.

Das erhaltene Harz (A1) besitzt laut SEC (Eluent THF) ein Molekulargewicht von Mw = 1900 g/mol und Mn = 1000 g/mol.

Der Silanolgehalt wird im ¹H-NMR zu 195 ppm bestimmt.

Der Vinylgehalt ist 2,64 mmol/g, der Gehalt an Si-gebundenem Wasserstoff 2,54 mmol/g.

Nach ²⁹Si-NMR ist die molare Zusammensetzung:
ViMe₂SiO_{1/2}: 27,4 %,
Me₂(H)SiO_{1/2}: 26,3 %,
Me₂SiO_{2/2}: 1,2 %,
Ph(OH)₂SiO_{1/2}: 0,0 %,
Ph(OH)SiO_{2/2}: 8,3% und
PhSiO_{3/2}: 36,8 %.

Das Produkt ist frei von Alkoxysilylgruppen.

### Herstellung eines Si-H und Si-Vinyl bifunktionellen Phenylharzes mit SiH/Vi = 1,15 (A2)

Es wird analog der Herstellung von Harz (A1) vorgegangen. Als Apparatur wird ein 4 l Kolben verwendet. Die Einsatzmengen werden wie folgt gewählt:
vollentsalztes Wasser: 1350 g
Vinyldimethylchlorsilan (Molekulargewicht 120,5 g/mol): 188,9 g (1,57 mol)
Phenyltrichlorsilan (Molekulargewicht 211,5 g/mol): 674,85 g (3,19 mol)
Dimethylchlorsilan in der Chlorsilanmischung: 115,48 g (1,23 mol)
Dimethylchlorsilan zur späteren Dosierung: 73,22 g (0,78 mol).

Die Waschungen erfolgen bei 45°C. Das Produkt wird bei 100°C und 6 mbar am Rotationsverdampfer entflüchtigt. Man erhält 470 g eines klaren Produktes mit einer Viskosität von 548 mPas und einem Brechungsindex n_{D}²⁵ von 1,502.

Das erhaltene Harz (A2) weist laut SEC (Eluent THF) ein Molekulargewicht von Mw = 1700 g/mol und Mn = 1100 g/mol auf.

Der Silanolgehalt wird im ¹H-NMR zu 394 ppm bestimmt.

Der Vinylgehalt ist 2,15 mmol/g, der Gehalt an Si-gebundenem Wasserstoff 2,52 mmol/g.

Nach ²⁹Si-NMR ist die molare Zusammensetzung:
ViMe₂SiO_{1/2}: 23,0 %,
Me₂(H)SiO_{1/2}: 27,2 %,
Ph(OH)SiO_{2/2}: 9,8 % und
PhSiO_{3/2}: 40,0 %.

Das Produkt ist frei von Alkoxysilylgruppen.

### Herstellung eines Si-H und Si-Vinyl bifunktionellen Phenylharzes mit SiH/Vi = 2,3 (A3)

Es wird analog der Herstellung von Harz (A1) vorgegangen. Als Apparatur wird ein 4 l Kolben verwendet. Die Einsatzmengen werden wie folgt gewählt:
vollentsalztes Wasser: 1320 g
Vinyldimethylchlorsilan: 107,38 g (0,89 mol)
Phenyltrichlorsilan (Molekulargewicht 211,5 g/mol): 674,85 g (3,19 mol)
Dimethylchlorsilan in der Chlorsilanmischung: 156,63 g (1,65 mol)
Dimethylchlorsilan zur späteren Dosierung: 96,00 g (1,01 mol).

Die Waschungen erfolgen bei 45°C. Das Produkt wird bei 100°C und 6 mbar am Rotationsverdampfer entflüchtigt. Man erhält 413 g eines klaren Produktes mit einer Viskosität von 861 mPas und einem Brechungsindex n_{D}²⁵ von 1,504.

Das erhaltene Harz (A3) weist laut SEC (Eluent THF) ein Molekulargewicht von Mw = 2000 g/mol und Mn = 1200 g/mol auf.

Der Silanolgehalt wird im ¹H-NMR zu 680 ppm bestimmt.

Der Vinylgehalt ist 1,3 mmol/g, der Gehalt an Si-gebundenem Wasserstoff 3,18 mmol/g.

Nach ²⁹Si-NMR ist die molare Zusammensetzung:
ViMe₂SiO_{1/2}: 14,4 %,
Me₂(H)SiO_{1/2}: 34,1%,
Ph(OH)SiO_{2/2} : 10,2 % und
PhSiO_{3/2}: 41,3 %.

Das Produkt ist frei von Alkoxysilylgruppen.

### Herstellung eines Si-H und Si-Vinyl bifunktionellen Phenylharzes mit SiH/Vi = 0,15 (A4)

Es wird analog der Herstellung von Harz (A1) vorgegangen. Als Apparatur wird ein 1 l Kolben verwendet. Die Einsatzmengen werden wie folgt gewählt:
vollentsalztes Wasser: 255 g
Vinyldimethylchlorsilan: 60,00 g (0,497 mol)
Phenyltrichlorsilan: 135,36 g (0,64 mol)
Dimethylchlorsilan in der Chlorsilanmischung: 5,23 g (0,055 mol) .

Die Waschungen erfolgen bei 45°C. Das Produkt wird bei 100°C und 6 mbar am Rotationsverdampfer entflüchtigt. Man erhält 84 g eines klaren Produktes mit einer Viskosität von 1390 mPas und einem Brechungsindex n_{D}²⁵ von 1,511.

Das erhaltene Harz (A4) weist laut SEC (Eluent THF) ein Molekulargewicht von Mw = 1900 g/mol und Mn = 1200 g/mol auf.

Der Silanolgehalt wird im ¹H-NMR zu 3373 ppm bestimmt.

Der Vinylgehalt ist 3,33 mmol/g, der Gehalt an Si-gebundenem Wasserstoff 0,46 mmol/g.

Nach ²⁹Si-NMR ist die molare Zusammensetzung:
ViMe₂SiO_{1/2}: 38,6 %,
Me₂(H)SiO_{1/2}: 5,8 %,
Ph(OH)SiO_{2/2}: 20,2 % und
PhSiO_{3/2}: 35,4 %.

Das Produkt ist frei von Alkoxysilylgruppen.

### Herstellung eines Si-H und Si-Vinyl bifunktionellen Phenylharzes mit SiH/Vi = 6,65 (A5)

Es wird analog der Herstellung von Harz (A1) vorgegangen. Die Einsatzmengen werden wie folgt gewählt:
vollentsalztes Wasser: 260 g
Vinyldimethylchlorsilan: 6,87 g (0,057 mol)
Phenyltrichlorsilan: 135,36 g (0,64 mol)
Dimethylchlorsilan in der Chlorsilanmischung: 48,52 g (0,513 mol) .

Die Waschungen erfolgen bei 45°C. Das Produkt wird bei 100°C und 6 mbar am Rotationsverdampfer entflüchtigt. Man erhält 74 g eines klaren Produktes mit einer Viskosität von 611 mPas und einem Brechungsindex n_{D}²⁵ von 1,506.

Das erhaltene Harz (A5) weist laut SEC (Eluent THF) ein Molekulargewicht von Mw = 1600 g/mol und Mn = 1100 g/mol auf.

Der Silanolgehalt wird im ¹H-NMR zu 1262 ppm bestimmt.

Der Vinylgehalt ist 0,47 mmol/g, der Gehalt an Si-gebundenem Wasserstoff 3,97 mmol/g.

Nach ²⁹Si-NMR ist die molare Zusammensetzung:
ViMe₂SiO_{1/2}: 6,0 %,
Me₂(H)SiO_{1/2}: 40,7 %,
Ph(OH)SiO_{2/2}: 14,9 % und
PhSiO_{3/2}: 38,4 %.

Das Produkt ist frei von Alkoxysilylgruppen.

### Herstellung eines Si-H und Si-Vinyl bifunktionellen Phenylharzes mit SiH/Vi = 2,10 (A6)

Es wird analog der Herstellung von Harz (A1) vorgegangen. Die Einsatzmengen werden wie folgt gewählt:
vollentsalztes Wasser: 270,00 g
Vinyldimethylchlorsilan: 18,89 g (0,157 mol)
Phenyltrichlorsilan: 134,97 g (0,638 mol)
Silan PM2: 26,73 g (0,156 mol)
Dimethylchlorsilan in der Chlorsilanmischung: 23,10 g (0,24 mol)
Dimethylchlorsilan zur späteren Dosierung: 14,64 g (0,15 mol).

Die Waschungen erfolgen bei 45°C. Das Produkt wird bei 100°C und 6 mbar am Rotationsverdampfer entflüchtigt. Man erhält 89 g eines klaren Produktes mit einer Viskosität von 314 mPas und einem Brechungsindex n_{D}²⁵ von 1,512.

Das erhaltene Harz (A6) weist laut SEC (Eluent THF) ein Molekulargewicht von Mw = 1700 g/mol und Mn = 1000 g/mol auf.

Der Silanolgehalt wird im ¹H-NMR zu 474 ppm bestimmt.

Der Vinylgehalt ist 1,00 mmol/g, der Gehalt an Si-gebundenem Wasserstoff 2,48 mmol/g.

Nach ²⁹Si-NMR ist die molare Zusammensetzung:
ViMe₂SiO_{1/2}: 12,2 %,
Me₂(H)SiO_{1/2}: 27,1 %,
Me₂PhSiO_{1/2}: 11,6 %,
Ph(OH)SiO_{2/2}: 11,9 % und
PhSiO_{3/2}: 37,2 %.

Das Produkt ist frei von Alkoxysilylgruppen.

### Herstellung eines Si-Vinyl funktionellen Phenylharzes (C1)

In einem 2 l Kolben werden 700 g Phenyltriethoxysilan (2,91 mol), 61,6 g Dimethyl-diethoxysilan (0,415 mol) und 77,6 g 1,3-Divinyl-1,1,3,3-tetramethyl-disiloxan (0,416 mol) homogen gemischt. Zu der Mischung werden unter Rühren 550 g Wasser gegeben und dann 3,0 g 20 %ige HCl. Die Mischung wird unter Rühren erwärmt und 2 h unter Rückfluss gekocht. Nach dem Abkühlen werden 4,5 g 20 %ige Natronlauge zugegeben und 30 min am Rückfluss gekocht. Bei einem Druck von 50 mbar wird entstandenes Ethanol abdestilliert und 800 ml Toluol zugegeben. Die wässrige Phase wird abgetrennt und die organische Phase drei Mal mit 500 ml Wasser gewaschen. Die organische Phase wird über Magnesiumsulfat getrocknet und das Produkt bei 140°C und 5 mbar am Rotationsverdampfer entflüchtigt. Man erhält 470 g eines klaren, sehr hochviskosen Produktes mit einer Glasübergangstemperatur von 5°C.

Das erhaltene Harz (C1) besitzt laut SEC (Eluent THF) ein Molekulargewicht von Mw = 2000 g/mol und Mn = 1400 g/mol.

Der Vinylgehalt ist 1,48 mmol/g.

Nach ²⁹Si-NMR ist die molare Zusammensetzung:
ViMe₂SiO_{1/2}: 17,9 %,
Me₂SiO_{2/2}: 11,0 %
Ph(OR)SiO_{2/2}: 18,0 % (R = H: 3 %; R = Ethyl: 15 %) und
PhSiO_{3/2}: 53,1 %.

### Herstellung eines Si-Vinyl funktionellen Phenylharzes (C2)

600 g Phenyltrichlorsilan (2,84 mol) und 113 g (0,936 mol) Vinyl-dimethyl-chlorsilan werden homogen gemischt und bei 50°C zu einer Mischung aus 600 g Wasser, 310 g Toluol und 190 g Ethylacetat zugetropft. Die Mischung wird anschließend zwei Stunden am Rückfluss gekocht. Nach Abkühlen der Mischung auf Raumtemperatur werden 700 ml Toluol zugegeben, die wässrige Phase abgetrennt und die organische Phase zwei Mal mit 1 l Wasser gewaschen, dann über Magnesiumsulfat getrocknet und das Lösungsmittel abdestilliert.

Man erhält 450 g eines klaren, sehr hochviskosen Produktes Produktes mit einer Glasübergangstemperatur von 10 °C.

Das erhaltene Harz (C2) besitzt laut SEC (Eluent THF) ein Molekulargewicht von Mw = 2200 g/mol und Mn = 1600 g/mol.

Der Vinylgehalt ist 1,85 mmol/g.

Nach ²⁹Si-NMR ist die molare Zusammensetzung:
ViMe₂SiO_{1/2}: 31,2 %,
Ph(OR)SiO_{2/2}: 30,2 % (R = H: 5 %; R = Ethyl 25 %) und
PhSiO_{3/2}: 38,6 %.

### Herstellung eines Si-Vinyl funktionellen Phenylharzes (C3)

In einem 2 l Kolben werden 700 g Phenyltriethoxysilan (2,91 mol), 217,6 g (1,6 mol bezogen auf PhMeSiO_{1/2}-Einheiten) eines kurzkettigen α,ω-silanolfunktionellen Phenylmethylöls eingelegt, das die durchschnittliche Zusammensetzung hat: (HO)PhMeSiO-[PhMeSiO]₄-PhMeSi-OH, das ein mittleres Molekulargewicht von Mw = 800 g/mol bei Mn = 700 g/mol hat und eine Viskosität von 503 mPas bei 25°C und Normaldruck von 1013 mbar aufweist, und 77,6 g 1,3-Divinyl-1,1,3,3-tetramethyl-disiloxan (0,416 mol) homogen gemischt. Zu der Mischung werden unter Rühren 550 g Wasser gegeben und dann 3,0 g 20 %ige HCl. Die Mischung wird unter Rühren erwärmt und 2 h unter Rückfluss gekocht. Nach dem Abkühlen werden 4,5 g 20 %ige Natronlauge zugegeben und 30 min am Rückfluss gekocht. Bei einem Druck von 50 mbar wird entstandenes Ethanol abdestilliert und 800 ml Toluol zugegeben. Die wässrige Phase wird abgetrennt und die organische Phase drei Mal mit 500 ml Wasser gewaschen. Die organische Phase wird über Magnesiumsulfat getrocknet und das Produkt bei 140°C und 5 mbar am Rotationsverdampfer entflüchtigt. Man erhält 595 g eines klaren, sehr hochviskosen Produktes.

Das erhaltene Harz (C3) besitzt laut SEC (Eluent THF) ein Molekulargewicht von Mw = 2300 g/mol und Mn = 1500 g/mol.

Der Vinylgehalt ist 1,1 mmol/g.

Nach ²⁹Si-NMR ist die molare Zusammensetzung:
ViMe₂SiO_{1/2}: 15,2 %,
Me₂SiO_{2/2}: 30,9 %
Ph(OR)SiO_{2/2}: 13 % (R = H: 4 %; R = Ethyl: 9 %) und
PhSiO_{3/2}: 40,9 %.

### Beispiele

In den nachfolgenden Beispielen werden die Formulierungen wie folgt hergestellt:
Die Formulierungen werden durch Herstellung von homogenen Mischungen der jeweils angegebenen Komponenten an einem Speedmixer der Firma Hauschild, Typ DAC 150 FV und anschließendem Entgasen der Probe mit einer Öldiffusionspumpe oder an einem Planetary Mixer der Firma Thinky Corporation, Japan, Typ AWATORI RENTARO Model ARV-310 unter gleichzeitigem Evakuieren hergestellt.

Wenn nicht anders angegeben, werden die entgasten Mischungen in offene Stahlformen mit einem Durchmesser von 35 mm und einer Höhe von 6 mm gegossen und in einem Umlufttrockenschrank bei 150°C vulkanisieren gelassen. Die Vulkanisationszeit ist bei der jeweiligen Formulierung angegeben.

### Beispiel 1

An einem Planetary Mixer werden 80 Teile des Harzes (A2) mit 20 Teilen des Harzes (C1) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 58 auf.

### Beispiel 2

An einem Planetary Mixer werden 45 Teile des Harzes (A3) mit 55 Teilen des Harzes (C1) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 65 auf.

### Beispiel 3

An einem Planetary Mixer werden 35 Teile des Harzes (A5) mit 65 Teilen des Harzes (C1) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 70 auf.

### Beispiel 4

An einem Planetary Mixer werden 60 Teile des Harzes (A6) mit 40 Teilen des Harzes (C1) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 30 auf.

### Beispiel 5

An einem Planetary Mixer werden 70 Teile des Harzes (A2) mit 30 Teilen des Harzes (C3) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 45 auf.

### Beispiel 6

An einem Planetary Mixer werden 60 Teile des Harzes (A2) mit 30 Teilen des Harzes (C1), 10 Teilen eines vinyl-terminierten Poly-dimethyl-phenylmethyl-siloxans mit der Zusammensetzung (Me₂ViSiO_{1/2})₂(MePhSiO_{2/2})₆₀(Me₂SiO_{2/2})₁₂ (Brechungsindex n_{D}²⁵ = 1,538, Viskosität η = 7800 mPas) und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 40 auf.

### Beispiel 7

An einem Planetary Mixer werden 60 Teile des Harzes (A2) mit 40 Teilen des Harzes (C1) und 0,002 Teilen (bezogen auf Platin) Methylcyclopentadienyltrimethylplatin (IV) vermischt. Die Mischung wird entgast, in eine offene Stahlform mit einem Durchmesser von 35 mm und einer Höhe von 6 mm gegossen und mit einem Eisen-Strahler ("D-bulb") der Fa. Hönle, Gräfelfing, Deutschland mit 140 mW/cm² 15 Sekunden bestrahlt. Das Vulkanisat weist eine Härte Shore D von 50 auf.

### Beispiel 8

An einem Planetary Mixer werden 60 Teile des Harzes (A2) mit 30 Teilen des Harzes (C1), 10 Teilen eines vinyl-terminierten Poly-dimethyl-phenylmethyl-siloxans mit der Zusammensetzung (Me₂ViSiO_{1/2})₂(MePhSiO_{2/2})₆₀(Me₂SiO_{2/2})₁₂ (Brechungsindex n_{D}²⁵ = 1,538, Viskosität η = 7800 mPas), 0,5 Teilen (3-Glycidoxypropyl)trimethoxysilan und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 40 auf.

### Vergleichsbeispiel 1

An einem Planetary Mixer werden 70 Teile des Harzes (C2) mit 10 Teilen eines vinyl-terminierten Poly-dimethyl-phenylmethylsiloxans mit der Zusammensetzung (Me₂ViSiO_{1/2})₂(MePhSiO_{2/2})₆₀(Me₂SiO_{2/2})₁₂ (Brechungsindex n_{D}²⁵ = 1,538, Viskosität η = 7800 mPas), 20 Teilen 1,1,5,5-Tetramethyl-3,3-diphenyl-trisiloxan und 0,0002 Teilen (bezogen auf Platin) eines Platin-1,3-Divinyl-1,1,3,3-tetramethyldisiloxan-Komplexes vermischt. Die Mischung wird 2 h bei 150°C vulkanisiert. Das Vulkanisat weist eine Härte Shore A von 60 auf.

### Vergleichsbeispiel 2

An einem Planetary Mixer werden 65 Teile des Harzes (C2) mit 35 Teilen 1,1,5,5-Tetramethyl-3,3-diphenyl-trisiloxan und 0,0002 Teilen (bezogen auf Platin) eines Platin-1,3-Divinyl-1,1,3,3-tetramethyldisiloxan-Komplexes vermischt. Die Mischung wird 4 h bei 150°C vulkanisiert. Das Vulkanisat weist eine Härte Shore D von 38 auf.

### Beispiel 9

An einem Planetary Mixer werden 50 Teile des Harzes (A3) mit 50 Teilen des Harzes (C1), 0,5 Teilen (3-Glycidoxypropyl)trimeth-oxysilan und 0,0002 Teilen (bezogen auf Platin) eines Platin-1,3-Divinyl-1,1,3,3-tetramethyldisiloxan-Komplexes vermischt. Die Mischung wird 1 h bei 150°C vulkanisiert. Das Vulkanisat weist eine Härte Shore D von 68 auf.

## Patentansprüche

1. Zusammensetzungen enthaltend
(A) Organopolysiloxane aus mindestens 3 Einheiten der Formel
R¹ₐR²_{b}R³_{c}H_{d}(RO)ₑSiO_{(4-a-b-c-d-e)/2} (I),
wobei
R¹ gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
R² gleich oder verschieden sein kann und einwertige, SiC-gebundene, gegebenenfalls halogen- oder cyanosubstituierte, gesättigte Kohlenwasserstoffreste darstellen,
R³ gleiche oder verschiedene einwertige SiC-gebundene aromatische Reste darstellen,
R gleich oder verschieden sein kann und Wasserstoffatom oder einwertige, gegebenenfalls substituierte Kohlenwasserstoffreste darstellen, die mit Heteroatomen unterbrochen sein können,
a 0, 1, 2 oder 3 ist,
b 0, 1, 2 oder 3 ist,
c 0, 1, 2 oder 3 ist,
d 0, 1 oder 2 ist und
e 0, 1 oder 2 ist,
mit der Maßgabe, dass die Summe a+b+c+d+e kleiner oder gleich 3 ist, die Summe aus Si-gebundenen Wasserstoffatomen und Resten R¹ pro Molekül mindestens 3 beträgt, in mindestens 10 mol-% der Einheiten der Formel (I) die Summe a+b+c+d gleich 0 oder 1 ist und in mindestens einer Einheit c verschieden 0 ist sowie im Siloxan (A) das Verhältnis von Si-gebundenen Wasserstoffatomen zu Si-gebundenen Resten R¹ bei 0,1 bis 9 liegt,
gegebenenfalls (B) Organopolysiloxane aus Einheiten der Formel
R⁴_{f}R⁵_{g}R⁶ₕ(R⁷O)ᵢSiO_{(4-f-g-h-i)/2} (VI),
wobei
R⁴ gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
R⁵ gleich oder verschieden sein kann und einwertige, SiC-gebundene, gegebenenfalls halogen- oder cyanosubstituierte, gesättigte Kohlenwasserstoffreste darstellen,
R⁶ gleiche oder verschiedene einwertige SiC-gebundene aromatische Reste darstellen,
R⁷ gleich oder verschieden sein kann und Wasserstoffatom oder einwertige, gegebenenfalls substituierte Kohlenwasserstoffreste darstellen, die mit Heteroatomen unterbrochen sein können,
f 0, 1, 2 oder 3 ist,
g 0, 1, 2 oder 3 ist,
h 0, 1 oder 2 ist und
i 0 oder 1 ist,
mit der Maßgabe, dass die Summe f+g+h+i kleiner oder gleich 3 ist, Siloxane (B) mindestens zwei Reste R⁴ pro Molekül aufweisen, in maximal 20 mol-% der Einheiten der Formel (VI) die Summe f+g+h+i gleich 0 oder 1 ist und in mindestens einer Einheit der Formel (VI) h verschieden 0 ist,
(C) Organopolysiloxane aus Einheiten der Formel
R⁸ₖR⁹ₗR¹⁰ₘ(R¹¹O)ₙSiO_{(4-k-l-m-n)/2} (X),
wobei
R⁸ gleich oder verschieden sein kann und einwertige, SiC-gebundene, gegebenenfalls halogen- oder cyanosubstituierte, aliphatische Kohlenstoff-Kohlenstoff-Mehrfachbindung aufweisende Kohlenwasserstoffreste darstellen,
R⁹ gleich oder verschieden sein kann und einwertige, SiC-gebundene, gegebenenfalls halogen- oder cyanosubstituierte, gesättigte Kohlenwasserstoffreste darstellen,
R¹⁰ gleiche oder verschiedene einwertige SiC-gebundene aromatische Reste darstellen,
R¹¹ gleich oder verschieden sein kann und Wasserstoffatom oder einwertige, gegebenenfalls substituierte Kohlenwasserstoffreste darstellen, die mit Heteroatomen unterbrochen sein können,
k 0, 1, 2 oder 3 ist,
l 0, 1, 2 oder 3 ist,
m 0, 1 oder 2 ist und
n 0 oder 1 ist,
mit der Maßgabe, dass die Summe k+l+m+n kleiner oder gleich 3 ist, Siloxane (C) mindestens zwei Reste R⁸ pro Molekül aufweisen, in mindestens 10 mol-% der Einheiten der Formel (X) die Summe k+l+m+n gleich 0 oder 1 ist und in mindestens einer Einheit der Formel (X) m verschieden 0 ist,
sowie
gegebenenfalls (D) die Anlagerung von Si-gebundenem Wasserstoff an aliphatische Kohlenstoff-Kohlenstoff-Mehrfachbindungen fördernden Katalysator.

2. Zusammensetzung gemäß Anspruch 1, **dadurch gekennzeichnet, dass** es sich bei Siloxane (A) um Siloxane mit mindestens 3 Einheiten ausgewählt aus solchen der Formeln
R¹ₐR²_{b}R³_{c}H_{d}(RO)ₑSiO_{1/2} mit (a+b+c+d+e) = 3 (II),
R²_{b}R³_{c}(RO)SiO_{2/2} mit (b+c) = 1 (IIIa),
R²_{b}R³_{c}SiO_{2/2} mit (b+c) = 2 (IIIb),
R²_{b}R³_{c}(RO)ₑSiO_{3/2} mit (b+c+e) = 1 (IV)
und
SiO_{4/2} (V)
handelt, wobei R, R¹, R², R³, a, b, c, d und e eine der oben angegebenen Bedeutungen haben,
mit der Maßgabe, dass in den Siloxanen (A) maximal 25 mol-%, der Einheiten der Formel (IIIb) entsprechen, die Summe aus Si-gebundenen Wasserstoffatomen und Resten R¹ pro Molekül mindestens 3 ist, pro Molekül mindestens ein Rest R³ anwesend ist und mindestens eine Einheit der Formel (IV) und/oder (V) anwesend ist.

3. Zusammensetzung gemäß Anspruch 1 oder 2, **dadurch gekennzeichnet, dass** es sich bei Komponente (C) um Siloxane bestehend aus Einheiten ausgewählt aus solchen der Formeln
R⁸ₖR⁹ₗR¹⁰ₘ(R¹¹O)ₙSiO_{1/2} mit (k+l+m+n)= 3 (XI),
R⁹ₗR¹⁰ₘ(R¹¹O)SiO_{2/2} mit (l+m) = 1 (XIIa),
R⁹ₗR¹⁰ₘSiO_{2/2} mit (l+m) = 2 (XIIb),
R⁹ₗR¹⁰ₘ(R¹¹O)ₙSiO_{3/2} mit (l+m+n) = 1 (XIII)
und
SiO_{4/2} (V)
handelt, wobei R⁸, R⁹, R¹⁰, R¹¹, k, l, m und n eine der oben angegebenen Bedeutungen hat,
mit der Maßgabe, dass die Siloxane (C) mindestens zwei Reste R⁸ pro Molekül aufweisen, pro Molekül mindestens ein Rest R¹⁰ anwesend ist und mindestens eine Einheit der Formel (XIII) und/oder (V) anwesend ist.

4. Zusammensetzung gemäß einem oder mehreren der Ansprüche 1 bis 3, **dadurch gekennzeichnet, dass** sie 1 bis 200 Gewichtsteile Siloxan (C), bezogen auf 100 Gewichtsteile Komponente (A), enthalten.

5. Zusammensetzung gemäß einem oder mehreren der Ansprüche 1 bis 4, **dadurch gekennzeichnet, dass** es sich um solche handelt enthaltend
(A) Siloxane aus Einheiten der Formel (I),
gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
gegebenenfalls (E) Füllstoffe,
gegebenenfalls (F) Haftvermittler,
gegebenenfalls (G) Inhibitoren,
gegebenenfalls (H) Weichmacher,
gegebenenfalls (K) Additive und
gegebenenfalls (L) Lösungsmittel.

6. Zusammensetzung gemäß einem oder mehreren der Ansprüche 1 bis 4, **dadurch gekennzeichnet, dass** es sich um solche handelt enthaltend
(A) Siloxane aus Einheiten der Formel (I),
gegebenenfalls (B) Siloxane aus Einheiten der Formel (VI),
(C) Siloxane aus Einheiten der Formel (X),
(D) die Anlagerung von Si-gebundenem Wasserstoff an aliphatische Kohlenstoff-Kohlenstoff-Mehrfachbindungen fördernden Katalysator,
gegebenenfalls (E) Füllstoffe,
(F) Haftvermittler,
gegebenenfalls (G) Inhibitoren,
gegebenenfalls (H) Weichmacher,
gegebenenfalls (K) Additive und
gegebenenfalls (L) Lösungsmittel.

7. Verfahren zur Herstellung der Zusammensetzungen gemäß einem oder mehreren der Ansprüche 1 bis 6 durch Mischen der einzelnen Komponenten in beliebiger Reihenfolge.

8. Formkörper hergestellt durch Vernetzung der Zusammensetzungen gemäß einem oder mehreren der Ansprüche 1 bis 6 oder hergestellt nach Anspruch 7.

9. Formkörper gemäß Anspruch 8, **dadurch gekennzeichnet, dass** es sich um Beschichtungen, Verguss oder Linsen handelt.

10. Verwendung der Zusammensetzungen gemäß einem oder mehreren der Ansprüche 1 bis 6 oder hergestellt nach Anspruch 7 als Vergussmassen in elektrischen und elektronischen Anwendungen.

11. Verwendung der Zusammensetzungen gemäß einem oder mehreren der Ansprüche 1 bis 6 oder hergestellt nach Anspruch 7 als Vergussmassen zur Herstellung von LEDs.

## Claims

1. Compositions containing
(A) organopolysiloxanes formed of at least 3 units of the formula
R¹ₐR²_{b}R³_{c}H_{d}(RO)ₑSiO_{(4-a-b-c-d-e)/2} (I),
where
R¹ represents monovalent, SiC-bonded, optionally halogen- or cyano-substituted, hydrocarbyl moieties with aliphatic carbon-carbon multiple bonding and may be the same or different at each occurrence,
R² represents monovalent, SiC-bonded, optionally halogen- or cyano-substituted, saturated hydrocarbyl moieties and may be the same or different at each occurrence,
R³ represents identical or different monovalent SiC-bonded aromatic moieties,
R represents a hydrogen atom or monovalent, optionally substituted hydrocarbyl moieties, which may be interrupted by heteroatoms, and may be the same or different at each occurrence,
a is 0, 1, 2 or 3,
b is 0, 1, 2 or 3,
c is 0, 1, 2 or 3,
d is 0, 1 or 2, and
e is 0, 1 or 2,
with the proviso that the a+b+c+d+e sum is not more than 3, the sum total of Si-bonded hydrogen atoms and R¹ moieties per molecule is at least 3, the a+b+c+d sum is equal to 0 or 1 in at least 10 mol% of the units of formula (I) and c is other than 0 in at least one unit and the ratio of Si-bonded hydrogen atoms to Si-bonded R¹ moieties in the siloxane (A) is from 0.1 to 9,
optionally (B) organopolysiloxanes formed of units of the formula
R⁴_{f}R⁵_{g}R⁶ₕ(R⁷O)ᵢSiO_{(4-f-g-h-i)/2} (VI),
where
R⁴ represents monovalent, SiC-bonded, optionally halogen- or cyano-substituted, hydrocarbyl moieties with aliphatic carbon-carbon multiple bonding and may be the same or different at each occurrence,
R⁵ represents monovalent, SiC-bonded, optionally halogen- or cyano-substituted, saturated hydrocarbyl moieties and may be the same or different at each occurrence,
R⁶ represents identical or different monovalent SiC-bonded aromatic moieties,
R⁷ represents a hydrogen atom or monovalent, optionally substituted hydrocarbyl moieties, which may be interrupted by heteroatoms, and may be the same or different at each occurrence,
f is 0, 1, 2 or 3,
g is 0, 1, 2 or 3,
h is 0, 1 or 2,
i is 0 or 1,
with the proviso that the f+g+h+i sum is not more than 3, siloxanes (B) having at least two R⁴ moieties per molecule, the f+g+h+i sum is equal to 0 or 1 in not more than 20 mol% of the units of formula (VI) and h is other than 0 in at least one unit of formula (VI),
(C) organopolysiloxanes formed of units of the formula
R⁸ₖR⁹ₗR¹⁰ₘ (R¹¹O)ₙSiO_{(4-k-l-m-n)/2} (X),
where
R⁸ represents monovalent, SiC-bonded, optionally halogen- or cyano-substituted, hydrocarbyl moieties with aliphatic carbon-carbon multiple bonding and may be the same or different at each occurrence,
R⁹ represents monovalent, SiC-bonded, optionally halogen- or cyano-substituted, saturated hydrocarbyl moieties and may be the same or different at each occurrence,
R¹⁰ represents identical or different monovalent SiC-bonded aromatic moieties,
R¹¹ represents a hydrogen atom or monovalent, optionally substituted hydrocarbyl moieties, which may be interrupted by heteroatoms, and may be the same or different at each occurrence,
k is 0, 1, 2 or 3,
1 is 0, 1, 2 or 3,
m is 0, 1 or 2, and
n is 0 or 1,
with the proviso that the k+l+m+n sum is not more than 3, siloxanes (C) having at least two R⁸ moieties per molecule, the k+l+m+n sum is equal to 0 or 1 in at least 10 mol% of the units of formula (X) and m is other than 0 in at least one unit of formula (X),
and also
optionally (D) a catalyst to promote the addition of Si-bonded hydrogen onto aliphatic carbon-carbon multiple bonds.

2. Composition according to Claim 1, **characterized in that** said siloxanes (A) comprise siloxanes having at least 3 units selected from those of the formulae R¹
ₐR²_{b}R³_{c}H_{d}(RO)ₑSiO_{1/2} where (a+b+c+d+e) = 3 (II),
R²_{b}R³_{c}(RO)SiO_{2/2} where (b+c) = 1 (IIIa),
R²_{b}R³_{c}SiO_{2/2} where (b+c) = 2 (IIIb),
R²_{b}R³_{c}(RO)ₑSiO_{3/2} where (b+c+e) = 1 (IV),
and
SiO_{4/2} (V),
where R, R¹, R², R³, a, b, c, d and e are each as defined above,
with the proviso that not more than 25 mol% of the units in said siloxanes (A) conform to formula (IIIb), the sum total of Si-bonded hydrogen atoms and R¹ moieties per molecule is at least 3, at least one R³ moiety is present per molecule and at least one unit of formula (IV) and/or (V) is present.

3. Composition according to Claim 1 or 2, **characterized in that** said component (C) comprises siloxanes consisting of units selected from those of the formulae
R⁸ₖR⁹ₗ,R¹⁰ₘ(R¹¹O)ₙSiO_{1/2} where (k+l+m+n)= 3 (XI),
R⁹ₗR¹⁰ₘ(R¹¹O)SiO_{2/2} where (l+m) = 1 (XIIa),
R⁹ₗR¹⁰ₘSiO_{2/2} where (l+m) = 2 (XIIb),
R⁹ₗR¹⁰ₘ(R¹¹O)ₙSiO_{3/2} where (l+m+n) = 1 (XIII)
and
SiO_{4/2} (V)
where R⁸, R⁹, R¹⁰, R¹¹, k, l, m and n are each as defined above,
with the proviso that said siloxanes (C) have at least two R⁸ moieties per molecule, at least one R¹⁰ moiety is present per molecule and at least one unit of formula (XIII) and/or (V) is present.

4. Composition according to one or more of Claims 1 to 3, **characterized in that** they contain from 1 to 200 parts by weight of siloxane (C), based on 100 parts by weight of component (A).

5. Composition according to one or more of Claims 1 to 4, **characterized in that** it contains
(A) siloxanes formed of units of formula (I),
optionally (B) siloxanes formed of units of formula (VI),
(C) siloxanes formed of units of formula (X),
(D) a catalyst to promote the addition of Si-bonded hydrogen onto aliphatic carbon-carbon multiple bonds,
optionally (E) fillers,
optionally (F) adhesion promoters,
optionally (G) inhibitors,
optionally (H) plasticizers,
optionally (K) additives, and
optionally (L) solvents.

6. Composition according to one or more of Claims 1 to 4, **characterized in that** it contains
(A) siloxanes formed of units of formula (I),
optionally (B) siloxanes formed of units of formula (VI),
(C) siloxanes formed of units of formula (X),
(D) a catalyst to promote the addition of Si-bonded hydrogen onto aliphatic carbon-carbon multiple bonds,
optionally (E) fillers,
(F) adhesion promoters,
optionally (G) inhibitors,
optionally (H) plasticizers,
optionally (K) additives, and
optionally (L) solvents.

7. Process for producing the compositions according to one or more of Claims 1 to 6 by mixing the individual components in arbitrary order.

8. Shaped articles obtained by crosslinking the compositions according to one or more of Claims 1 to 6 or obtained according to Claim 7.

9. Shaped articles according to Claim 8, **characterized in that** coatings, encapsulation or lenses are concerned.

10. Use of compositions according to one or more of Claims 1 to 6 or obtained according to Claim 7 as encapsulation compounds in electrical and electronic applications.

11. Use of compositions according to one or more of Claims 1 to 6 or obtained according to Claim 7 as encapsulation compounds in the manufacture of LEDs.

## Revendications

1. Compositions contenant
(A) des organopolysiloxanes constitués par au moins 3 unités de formule
R¹ₐR²_{b}R³_{c}H_{d}(RO)ₑSiO_{(4-a-b-c-d-e)/2} (I),
dans laquelle
R¹ peut être identique ou différent et représente des radicaux hydrocarbonés monovalents, liés par SiC, le cas échéant substitués par halogène ou cyano, présentant une liaison carbone-carbone aliphatique multiple,
R² peut être identique ou différent et représente des radicaux hydrocarbonés monovalents, liés par SiC, le cas échéant substitués par halogène ou cyano, saturés,
R³ représente des radicaux aromatiques identiques ou différents, monovalents, liés par SiC,
R peut être identique ou différent et représente un atome d'hydrogène ou des radicaux hydrocarbonés monovalents, le cas échéant substitués, qui peuvent être interrompus par des hétéroatomes,
a vaut 0, 1, 2 ou 3,
b vaut 0, 1, 2 ou 3,
c vaut 0, 1, 2 ou 3,
d vaut 0, 1 ou 2 et
e vaut 0, 1 ou 2,
à condition que la somme a+b+c+d+e soit inférieure ou égale à 3, la somme des atomes d'hydrogène liés par Si et des radicaux R¹ par molécule vaille au moins 3, dans au moins 10% en mole des unités de formule (I) la somme a+b+c+d soit égale à 0 ou 1 et dans au moins une unité c soit différent de 0 ainsi que, dans le siloxane (A), le rapport d'atomes d'hydrogène liés par Si aux radicaux R¹ liés par Si se situe à 0,1 à 9,
le cas échéant (B) des organopolysiloxanes constitués par des unités de formule
R⁴_{f}R⁵_{g}R⁶ₕ(R⁷O)ᵢSiO_{(4-f-g-h-i)/2} (VI),
dans laquelle
R⁴ peut être identique ou différent et représente des radicaux hydrocarbonés monovalents, liés par SiC, le cas échéant substitués par halogène ou cyano, présentant une liaison carbone-carbone aliphatique multiple,
R⁵ peut être identique ou différent et représente des radicaux hydrocarbonés monovalents, liés par SiC, le cas échéant substitués par halogène ou cyano, saturés,
R⁶ représente des radicaux aromatiques identiques ou différents, monovalents, liés par SiC,
R⁷ peut être identique ou différent et représente un atome d'hydrogène ou des radicaux hydrocarbonés monovalents, le cas échéant substitués, qui peuvent être interrompus par des hétéroatomes,
f vaut 0, 1, 2 ou 3,
g vaut 0, 1, 2 ou 3,
h vaut 0, 1 ou 2 et
i vaut 0 ou 1,
à condition que la somme f+g+h+i soit inférieure ou égale à 3, les siloxanes (B) présentent au moins deux radicaux R⁴ par molécule, dans au maximum 20% en mole des unités de formule (VI) la somme f+g+h+i soit égale à 0 ou 1 et dans au moins une unité de formule (VI) h soit différent de 0,
(C) des organopolysiloxanes constitués par des unités de formule
R⁸ₖR⁹ₗR¹⁰ₘ(R¹¹O)ₙSiO_{(4-k-l-m-n)/2} (X),
dans laquelle
R⁸ peut être identique ou différent et représente des radicaux hydrocarbonés monovalents, liés par SiC, le cas échéant substitués par halogène ou cyano, présentant une liaison carbone-carbone aliphatique multiple,
R⁹ peut être identique ou différent et représente des radicaux hydrocarbonés monovalents, liés par SiC, le cas échéant substitués par halogène ou cyano, saturés,
R¹⁰ représente des radicaux aromatiques identiques ou différents, monovalents, liés par SiC,
R¹¹ peut être identique ou différent et représente un atome d'hydrogène ou des radicaux hydrocarbonés monovalents, le cas échéant substitués, qui peuvent être interrompus par des hétéroatomes,
k vaut 0, 1, 2 ou 3,
l vaut 0, 1, 2 ou 3,
m vaut 0, 1 ou 2 et
n vaut 0 ou 1,
à condition que la somme k+l+m+n soit inférieure ou égale à 3, les siloxanes (C) présentent au moins deux radicaux R⁸ par molécule, dans au moins 10% en mole des unités de formule (X) la somme k+l+m+n soit égale à 0 ou 1 et dans au moins une unité de formule (X) m soit différent de 0, ainsi que le cas échéant (D) un catalyseur qui favorise l'addition d'hydrogène lié par Si sur des liaisons multiples aliphatiques carbone-carbone.

2. Composition selon la revendication 1, **caractérisée en ce qu'**il s'agit, pour les siloxanes (A), de siloxanes présentant au moins 3 unités choisies parmi celles des formules
R¹ₐR²_{b}R³_{c}H_{d}(RO)eSiO_{1/2} avec (a+b+c+d+e) = 3 (II),
R²_{b}R³_{c}(RO)SiO_{2/2} avec (b+c) = 1 (IIIa),
R²_{b}R³_{c}SiO_{2/2} avec (b+c) = 2 (IIIb),
R²_{b}R³_{c}(RO)ₑSiO_{3/2} avec (b+c+e) = 1 (IV)
et
SiO_{4/2} (V)
R, R¹, R², R³, a, b, c, d et e présentant une des significations indiquées ci-dessus,
à condition que, dans les siloxanes (A), au maximum 25% en mole des unités correspondent à la formule (IIIb), la somme des atomes d'hydrogène liés par Si et des radicaux R¹ par molécule vaille au moins 3, par molécule au moins un radical R³ soit présent et au moins une unité de formule (IV) et/ou (V) soit présente.

3. Composition selon la revendication 1 ou 2, **caractérisée en ce qu'**il s'agit, pour le composant (C), de siloxanes constitués par des unités choisies parmi celles des formules
R⁸ₖR⁹ₗR¹⁰m(R¹¹O)ₙSiO_{1/2} avec (k+l+m+n)= 3 (XI),
R⁹ₗR¹⁰ₘ(R¹¹O)SiO_{2/2} avec (l+m) = 1 (XIIa),
R⁹ₗR¹⁰ₘSi_{O2/2} avec (l+m) = 2 (XIIb),
R⁹ₗR¹⁰ₘ(R¹¹O)ₙSiO_{3/2} avec (l+m+n) = 1 (XIII)
et
SiO_{4/2} (V)
R⁸, R⁹, R¹⁰, R¹¹, k, l, m et n présentant une des significations indiquées ci-dessus,
à condition que les siloxanes (C) présentent au moins deux radicaux R⁸ par molécule, au moins un radical R¹⁰ soit présent par molécule et au moins une unité de formule (XIII) et/ou (V) soit présente.

4. Composition selon l'une ou plusieurs des revendications 1 à 3, **caractérisée en ce qu'**elle contient 1 à 200 parties en poids de siloxane (C), par rapport à 100 parties en poids de composant (A).

5. Composition selon l'une ou plusieurs des revendications 1 à 4, **caractérisée en ce qu'**il s'agit de compositions contenant
(A) des siloxanes constitués par des unités de formule (I),
le cas échéant (B) des siloxanes constitués par des unités de formule (VI)
(C) des siloxanes constitués par des unités de formule (X),
(D) un catalyseur qui favorise l'addition d'hydrogène lié par Si sur des liaisons multiples aliphatiques carbone-carbone,
le cas échéant (E) des charges,
le cas échéant (F) des promoteurs d'adhérence,
le cas échéant (G) des inhibiteurs,
le cas échéant (H) des plastifiants,
le cas échéant (K) des additifs et
le cas échéant (L) des solvants.

6. Composition selon l'une ou plusieurs des revendications 1 à 4, **caractérisée en ce qu'**il s'agit de compositions contenant
(A) des siloxanes constitués par des unités de formule (I),
le cas échéant (B) des siloxanes constitués par des unités de formule (VI)
(C) des siloxanes constitués par des unités de formule (X),
(D) un catalyseur qui favorise l'addition d'hydrogène lié par Si sur des liaisons multiples aliphatiques carbone-carbone,
le cas échéant (E) des charges,
(F) des promoteurs d'adhérence,
le cas échéant (G) des inhibiteurs,
le cas échéant (H) des plastifiants,
le cas échéant (K) des additifs et
le cas échéant (L) des solvants.

7. Procédé pour la préparation des compositions selon l'une ou plusieurs des revendications 1 à 6 par mélange des différents composants dans un ordre quelconque.

8. Corps façonnés, préparés par réticulation des compositions selon l'une ou plusieurs des revendications 1 à 6 ou préparées selon la revendication 7.

9. Corps façonnés selon la revendication 8, **caractérisés en ce qu'**il s'agit de revêtements, de scellements ou de lentilles.

10. Utilisation des compositions selon l'une ou plusieurs des revendications 1 à 6 ou préparées selon la revendication 7 comme masses de scellement dans des applications électriques et électroniques.

11. Utilisation des compositions selon l'une ou plusieurs des revendications 1 à 6 ou préparées selon la revendication 7 comme masses de scellement pour la fabrication de DEL.
